# EUROPEAN PATENT APPLICATION

(11) **EP 4 793 554 A1**
(43) Date of publication of application: **19.08.2026**
(21) Application number: 26158032.8
(22) Date of filing: 12.02.2026
(51) Int. Cl.: F24C 15/00, F24C 15/10, H05B 6/12

(54) **COOKING APPLIANCE**

(30) Priority: 14.02.2025 KR 20250019608; 18.08.2025 KR 20250114500
(71) Applicant: LG Electronics Inc., Yeongdeungpo-gu Seoul 07336 (KR)
(72) Inventor: KIM, Wontae, 07796 Seoul (KR); SEO, Jungwoo, 07796 Seoul (KR); LEE, Sangcheol, 07796 Seoul (KR); PARK, Ki Hong, 07796 Seoul (KR); PARK, Byungkyu, 07796 Seoul (KR); HAN, Sol, 07796 Seoul (KR); LEE, Seung Ho, 07796 Seoul (KR); PARK, Kyungho, 07796 Seoul (KR); LEE, Dongha, 07796 Seoul (KR); LEE, Dongheon, 07796 Seoul (KR)
(74) Representative: Vossius & Partner Patentanwälte Rechtsanwälte mbB

(57) **Abstract**

Disclosed herein is a cooking appliance. The cooking appliance comprises a plurality of functional circuit parts and an electrical case accommodating the functional circuit parts, an internal space of the electrical case is partitioned into a plurality of electrical component spaces along an up-down direction, and the plurality of functional circuit parts are respectively disposed in different electrical component spaces.

## Description

### TECHNICAL FIELD

The present disclosure relates to a cooking appliance, and more particularly, to a cooking appliance that provides a function of suctioning and removing contaminants generated during a cooking process.

### BACKGROUND

Generally, a cooktop is a heating appliance installed on a countertop and provides a space in which food is cooked by a user. Such a cooktop includes a top plate disposed on an upper portion of the countertop, and the top plate forms a flat support surface to stably support a heating target object such as a pot, a frying pan, and the like.

Below the top plate, a heating part for actually heating the heating target object is disposed. The heating part may include a heating element such as an electric heater or an induction coil, and directly provides heat to the heating target object through heat or an electromagnetic field transmitted through the top plate. The heating part may be configured in a plurality of zones such as two zones, three zones, or four zones depending on cooking performance, and each zone is designed to be independently controllable.

Such a cooktop typically includes an operation panel for controlling the heating part, and a user may select or adjust heating intensity, a timer, a lock function, and the like through the operation panel. The operation panel may be integrally formed on an upper surface of the top plate, or may be separately provided on a side surface or a lower side. Each heating part is electrically connected to electrical components for controlling a corresponding circuit thereof, and typically, these electrical components are concentrically disposed in a lower space of the cooking appliance.

In recent years, as various functions such as cooking control, safety detection, and display have been integrated into the cooktop itself, multifunctional cooking appliances exceeding a simple heating function have emerged. Accordingly, various electrical components for performing various functions are also mounted inside the cooking appliance.

In particular, when a hood function is combined with a cooktop, not only components such as a suction fan, a filter, and a flow path but also electrical components for controlling the same should be disposed therein, and thus, securing a space for the electrical components is becoming more difficult. Accordingly, efficiently arranging a plurality of electrical components in a limited internal space has become an important task.

### SUMMARY

### Technical Problems

One objective of the present disclosure is to efficiently arrange electrical components in a limited space inside an electrical part.

Another objective of the present disclosure is to allow circuit stability and durability to be secured while electrical components are intensively arranged in a limited space inside an electrical part.

Still another objective of the present disclosure is to allow circuit performance efficiency and reliability to be secured while arrangement of electrical components is stably achieved.

### Technical Solutions

According to one embodiment of the present disclosure, a cooking appliance includes a plurality of functional circuit parts and an electrical case accommodating the functional circuit parts, an internal space of the electrical case being partitioned into a plurality of electrical component spaces along an up-down direction, wherein the plurality of functional circuit parts are respectively disposed in different electrical component spaces.

Another embodiment of the present disclosure is characterized in that an electrical part is disposed in a space covered by a top plate, an internal space of the electrical part being partitioned into a plurality of electrical component spaces along an up-down direction, and a plurality of functional circuit parts are respectively disposed in different electrical component spaces.

A cooking appliance according to one aspect of the present disclosure includes a top plate covering a component arrangement space, and an electrical part disposed in the component arrangement space, and the electrical part may include a plurality of functional circuit parts and an electrical case accommodating the functional circuit parts.

Further, an internal space of the electrical case may be partitioned into a plurality of electrical component spaces along an up-down direction, and the plurality of functional circuit parts may be respectively disposed in different electrical component spaces.

Further, the present disclosure may further include a plurality of heating parts that heat a heating target object disposed on the top plate.

Further, each of the heating parts may be electrically connected to one of the plurality of functional circuit parts.

Further, each of the functional circuit parts may be electrically connected to one or more of the heating parts, and include a plurality of electrical components that provide power or control signals for driving the heating parts.

Further, the present disclosure may further include a partition member disposed in the electrical component space.

Further, the internal space of the electrical case may be partitioned into the plurality of electrical component spaces by the partition member.

Further, the partition member may form a transverse surface extending across the electrical component space in a horizontal direction.

Further, the electrical component space may be partitioned into two electrical component spaces with the partition member as a boundary.

Further, the electrical component space may be partitioned into a first electrical component space that is disposed between a bottom surface of the electrical case and the partition member, and a second electrical component space that is disposed above the partition member.

Further, one of the functional circuit parts may be installed on a bottom surface of the electrical case and disposed in the first electrical component space, and another one of the functional circuit parts may be installed on the partition member and disposed in the second electrical component space.

Further, the second electrical component space may be disposed above the first electrical component space, and at least a portion of the functional circuit part disposed in the first electrical component space and at least a portion of the functional circuit part disposed in the second electrical component space may be disposed at positions offset from each other in a horizontal direction.

Further, each of the functional circuit parts may include a heat dissipation member on which heat-generating components are installed.

Further, the heat dissipation member disposed in the first electrical component space and the heat dissipation member disposed in the second electrical component space may be disposed at positions offset from each other in a horizontal direction.

Further, each of the functional circuit parts may include a first region in which a heat dissipation member, on which heat-generating components are installed, is disposed, and a second region in which the heat dissipation member is not disposed.

Further, the first region and the second region may be arranged in a horizontal direction, and the second region disposed in the first electrical component space and the second region disposed in the second electrical component space may be disposed at positions offset from each other in a horizontal direction.

Further, each of the electrical component spaces may include a first space portion and a second space portion that are partitioned in a horizontal direction.

Further, the functional circuit part may be disposed in the first space portion, and an electrical component other than the functional circuit part may be disposed in the second space portion.

Further, the functional circuit part may include an inverter circuit part that is provided for driving the heating part.

Further, at least one of a filter circuit part electrically connected to the inverter circuit part and a cooling fan for cooling the inverter circuit part may be disposed in the second space portion.

Further, the present disclosure may include a fan that introduces air into the component arrangement space.

Further, the electrical part may further include a motor driving circuit part that is provided for driving the fan.

Further, the motor driving circuit part may be disposed in the second space portion.

Further, the electrical part may further include a motor filter circuit part that is electrically connected to the motor driving circuit part.

Further, the motor driving circuit part may be disposed in the second electrical component space.

Further, the motor filter circuit part may be disposed in the first electrical component space and in the second space portion.

Further, the motor driving circuit part may be installed on an upper surface of the partition member.

Further, the motor filter circuit part may be installed on a lower surface of the partition member.

Further, the present disclosure may include a main circuit part that controls operation of the functional circuit part, and a power supply circuit part that supplies power to the main circuit part.

Further, the power supply circuit part may be disposed in the first electrical component space and in the second space portion.

Further, the present disclosure may include a fan that introduces air into the component arrangement space.

Further, the top plate may include an opening that opens the component arrangement space.

Further, the component arrangement space may include two partitioned spaces that are located on both sides of the opening in a horizontal direction.

Further, the fan may be disposed in only one of the two partitioned spaces.

Further, the electrical part may be disposed in the partitioned space in which the fan is not disposed.

Further, a lower end of the electrical part may be disposed at a position higher than a lower end of the fan.

Further, the present disclosure may include a filter that filters air between the opening and the fan, and a fluid collection part that collects fluid filtered from air by the filter.

Further, at least a portion of the fluid collection part may be disposed in the partitioned space in which the electrical part is disposed.

Further, the fluid collection part may be disposed below the top plate.

Further, in an up-down direction, the electrical part may be disposed between the top plate and the fluid collection part.

### Advantageous Effects

According to the present disclosure, an electrical component space of an electrical component part is partitioned into an upper/lower two-stage structure, and various electrical components including a functional circuit part are distributedly arranged in each space, whereby utilization of an internal space of a cooking appliance may be maximized. Accordingly, an effect of realizing a high-function circuit configuration may be provided without increasing a width in a horizontal direction.

In addition, the present disclosure may effectively suppress thermal interference and electromagnetic interference between components by arranging high heat-generating components such as an inverter circuit part and a motor driving circuit part in independent spaces and securing an arrangement distance between the same and auxiliary circuits. As a result, stability and durability of the circuit are improved, and stable operation may be achieved without performance deterioration of the electrical part even during a long-time cooking operation.

In addition, a third space portion formed below the inverter circuit part serves as a structural free space for heat diffusion, thereby smoothly inducing natural convection and a flow of cooling air. Accordingly, the present disclosure may provide an effect of improving heat generation stability of the inverter circuit part.

In addition, the present disclosure enables electrical components to be effectively accommodated without an increase in a horizontal size of the electrical part, and provides a very excellent technical effect of securing both circuit performance efficiency and reliability by stably arranging electrical components required for implementing a high-performance and high-function cooking appliance.

### BRIEF DESCRIPTION OF DRAWINGS

The accompanying drawings constitute a part of the specification, illustrate one or more embodiments in the disclosure, and together with the specification, explain the disclosure, wherein:
FIG. 1 is a view showing an installed state of a cooking appliance according to an embodiment of the present disclosure.
FIG. 2 is a front perspective view showing the cooking appliance shown in FIG. 1 in a disassembled state.
FIG. 3 is a rear perspective view of the cooking appliance shown in FIG. 2.
FIG. 4 is a view showing a state in which a top plate is removed from the cooking appliance shown in FIG. 2.
FIG. 5 is a plan sectional view showing an internal structure of the cooking appliance shown in FIG. 2.
FIG. 6 is a side sectional view showing an internal structure of the cooking appliance shown in FIG. 2.
FIGS. 7 and 8 are front sectional views showing an internal structure of the cooking appliance shown in FIG. 2.
FIG. 9 is a perspective view showing an exhaust device shown in FIG. 2 in a disassembled state.
FIG. 10 is a perspective view showing the fan shown in FIG. 9 in a disassembled state.
FIG. 11 is an exploded perspective view showing an exploded state of the fan shown in FIG. 10.
FIG. 12 is a view showing the filter shown in FIG. 9 in a disassembled state.
FIG. 13 is a perspective view showing an exploded state of the exhaust device shown in FIG. 9.
FIGS. 14 and 15 are perspective views showing an exploded state of a hood housing and a fan housing shown in FIG. 13.
FIG. 16 is a view showing an enlarged portion of the exhaust device shown in FIG. 9.
FIG. 17 is an exploded perspective view showing an exploded state of a fluid collection part shown in FIG. 16.
FIG. 18 is a front sectional view showing an internal structure of the fluid collection part shown in FIG. 16.
FIG. 19 is a front sectional view showing a component arrangement state in a component arrangement space.
FIGS. 20 and 21 are sectional views showing a fluid flow inside the exhaust device.
FIG. 22 is a front view showing a cooking appliance according to another embodiment of the present disclosure.
FIG. 23 is a block diagram showing a configuration of the cooking appliance shown in FIG. 22.
FIG. 24 is a front view showing the electrical part shown in FIG. 22 in a disassembled state.
FIG. 25 is a front sectional view showing an internal structure of the electrical part shown in FIG. 24.
FIG. 26 is a perspective view showing an internal structure of the electrical part shown in FIG. 24.
FIG. 27 is an exploded perspective view showing an exploded state of the electrical part shown in FIG. 26.
FIG. 28 is a sectional perspective view showing an internal structure of the electrical part shown in FIG. 26.
FIG. 29 is a view showing a first-floor stacked state of the electrical part.
FIGS. 30 and 31 are views showing a second-floor stacking process of the electrical part.
FIG. 32 is a perspective view showing a cooking appliance according to another embodiment of the present disclosure.
FIG. 33 is a block diagram showing a configuration of the cooking appliance shown in FIG. 32.
FIG. 34 is a front view of the cooking appliance shown in FIG. 32.
FIG. 35 is a bottom perspective view of the cooking appliance shown in FIG. 32.
FIG. 36 is a plan view of the cooking appliance shown in FIG. 32.
FIG. 37 is a plan view showing a state in which the top plate is removed from the cooking appliance shown in FIG. 35.
FIG. 38 is a perspective view showing a cooking appliance according to still another embodiment of the present disclosure.
FIG. 39 is a front view of the cooking appliance shown in FIG. 38.
FIG. 40 is a bottom perspective view of the cooking appliance shown in FIG. 38.
FIG. 41 is a block diagram showing a configuration of the cooking appliance shown in FIG. 38.
FIG. 42 is a front view showing the electrical part shown in FIG. 38 in a disassembled state.
FIG. 43 is a front sectional view showing an internal structure of the electrical part shown in FIG. 42.
FIG. 44 is a perspective view showing an internal structure of the electrical part shown in FIG. 42.
FIG. 45 is a bottom perspective view showing an internal structure of the electrical part shown in FIG. 42.

### DETAILED DESCRIPTION

The above-described aspects, features and advantages are specifically described hereafter with reference to accompanying drawings such that one having ordinary skill in the art to which the disclosure pertains can embody the technical spirit of the disclosure easily. In the *disclosure, detailed description* of known technologies in relation to the subject matter of the disclosure *is* omitted if it is deemed to *make* the *gist* of the *disclosure* unnecessarily *vague* Hereafter, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components are not to be limited by the terms. Certainly, a first component can be a second component, unless stated to the contrary.

Embodiments are not limited to the embodiments set forth herein, and can be modified and changed in various different forms. The embodiments in the disclosure are provided such that the disclosure can be through and complete and fully convey its scope to one having ordinary skill in the art. Accordingly, *all modifications, equivalents or replacements as well as a replacement of the configuration of any one embodiment with the configuration of another embodiment or an addition of the configuration of any one embodiment to the configuration of another embodiment, within* the technical spirit and scope of the disclosure, *are to be included in* the scope of the disclosure.

The accompanying drawings are provided for a better understanding of the embodiments set forth herein and are not intended to limit the technical spirit of the disclosure. It is to be understood that *all the modifications, equivalents or replacements within* the spirit and technical scope of the disclosure *are included in* the scope of the disclosure. The sizes or thicknesses of the components in the drawings are exaggerated or reduced to ensure ease of understanding and the like. However, the protection scope of the subject matter of the disclosure is not to be interpreted in a limited way.

The terms in the disclosure are used only to describe specific embodiments or examples and not intended to limit the subject matter of the disclosure. In the disclosure, singular forms include plural forms as well, unless explicitly indicated otherwise. In the disclosure, the terms "comprise", "comprised of" and the like specify the presence of stated features, integers, steps, operations, elements, components or combinations thereof but do not imply the exclusion of the presence or addition of one or more other features, integers, steps, operations, elements, components or combinations thereof.

The terms "first", "second" and the like are used herein only to distinguish one component from another component, and the components are not to be limited by the terms.

When any one component is described as "connected" or "coupled" to another component, any one component can be directly connected or coupled to another component, but an additional component can be "interposed" between the two components or the two components can be "connected" or "coupled" by an additional component. When any one component is described as "directly connected" or "directly coupled" to another component, an additional component cannot be "interposed" between the two components or the two components cannot be "connected" or "coupled" by an additional component.

When any one component is described as being "on (or under)" another component, any one component can be directly on (or under) another component, and an additional component can be interposed between the two components.

Unless otherwise defined, all the terms including technical or scientific terms used herein have the same meaning as commonly understood by one having ordinary skill in the art. Additionally, terms such as those defined in commonly used dictionaries are to be interpreted as having a meaning that is consistent with their meaning in the context of the relevant art, and unless explicitly defined herein, are not to be interpreted in an ideal way or an overly formal way.

In the state where a cooking appliance stands on the floor, a direction in which a door is installed with respect to the center of the cooking appliance is defined as a forward direction. Accordingly, a direction toward the inside of the cooking appliance with the door open is defined as a rearward direction. For convenience, the forward direction and the rearward direction can be referred to as a first direction. Then the forward direction is referred to as one direction of the first direction, and the rearward direction is referred to as the other direction of the first direction.

Additionally, a gravitational direction can be defined as a downward direction, and a direction opposite to the gravitational direction can be defined as an upward direction.

Further, a horizontal direction across a front-rear direction of the cooking appliance, i.e., a widthwise direction of the cooking appliance that is seen in front of the door of the cooking appliance, can be referred to as a left-right direction. For convenience, the left-right direction can be referred to as a second direction. Then the right side can be referred to as one direction of the second direction, and the left side can be referred to as the other direction of the second direction.

Further, the widthwise direction of the cooking appliance can also be referred to as a lateral direction. Then the right side can also be referred to as one side of the lateral direction, and the left side can be referred to the other side of the lateral direction.

Additionally, an up-down direction can be referred to as a third direction. Then an upward direction can be referred to as one direction of the third direction, and a downward direction can be referred to as the other direction of the third direction.

Furthermore, the up-down direction can be referred to as a vertical direction. Then the front-rear direction and the left-right direction, i.e., the first direction and the second direction, can be referred to as the horizontal direction.

Throughout the disclosure, the terms "A and/or B" as used herein can denote A, B or A and B, and the terms "C to D" can denote C or greater and D or less, unless stated to the contrary.

### [Entire structure of cooking appliance]

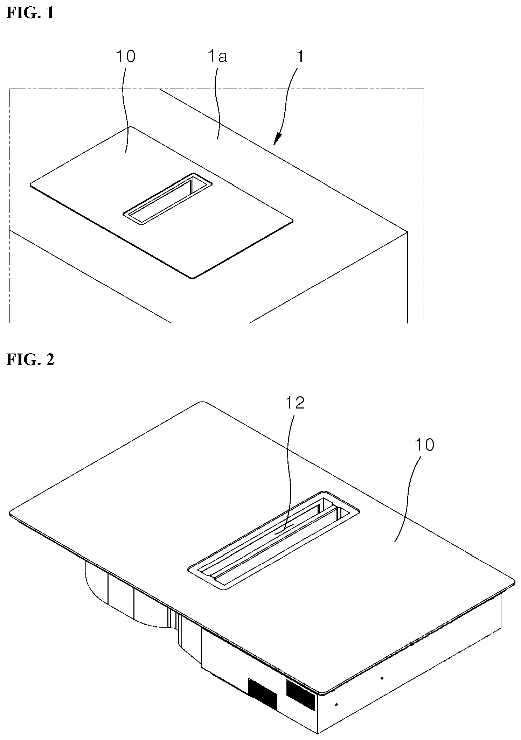

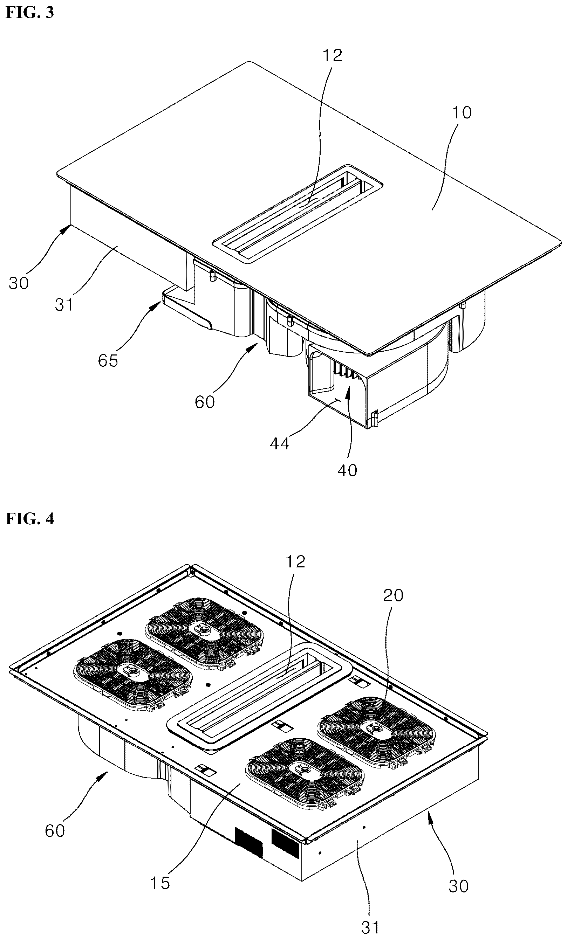

FIG. 1 is a view showing an installed state of a cooking appliance according to an embodiment of the present disclosure, and FIG. 2 is a front perspective view showing the cooking appliance shown in FIG. 1 in a disassembled state. Further, FIG. 3 is a rear perspective view of the cooking appliance shown in FIG. 2, and FIG. 4 is a view showing a state in which a top plate is removed from the cooking appliance shown in FIG. 2.

Referring to FIGS. 1 to 4, a cooking appliance according to an embodiment of the present disclosure may include a heating device and an exhaust device.

The heating device may be disposed on the upper portion of the cooking appliance. In the present embodiment, a heating device in the form of an electric range is exemplified. The cooking appliance exemplified herein is a concept including both an electric range of an electric resistance type and an electric range of an induction heating type. For convenience of description, embodiments of the present disclosure will be described mainly with reference to an electric range including a working coil as a heating part. However, the present disclosure is not limited thereto.

As an example, the heating device may include a top plate 10. The top plate 10 may be disposed at the upper portion of the heating device, and may form an outer appearance of an upper surface of the heating device and the cooking appliance. The top plate 10 is provided to cover the upper portion of the component arrangement space S.

The component arrangement space S is a space disposed vertically below the top plate 10, and is an area in which internal components of the cooking appliance are disposed. The component arrangement space S may, conceptually, be defined as an inner region surrounded by virtual vertical walls formed by vertically extending an outline of the top plate 10 in a horizontal direction.

In other words, an upper side of the component arrangement space S may be covered by the top plate 10, and a side portion and a lower portion thereof may not be completely surrounded by walls structurally, and may be in an open state. Accordingly, the component arrangement space S is not a closed chamber, but is an abstract space concept in which components are functionally disposed in the cooking appliance.

The top plate 10 may be positioned at an uppermost portion of the cooking appliance, and may be formed in a flat plate shape. The top plate 10 may provide a seating surface on which a container containing food (hereinafter, referred to as a "heating target") may be seated. As an example, the top plate 10 may be made of ceramic glass, and may be formed in the shape of a rectangular flat plate having a thickness.

At least one heating part 20 may be disposed in the cooking appliance. For example, a plurality of heating parts 20 may be arranged in a horizontal direction in the cooking appliance. Each heating part 20 may be disposed on the top plate, or may be disposed around the top plate, such as above or below the top plate.

As an example, each heating part 20 may include a working coil disposed below the top plate 10. As another example, the heating part 20 may include a burner that combusts gas, or may be provided in a form including a hot plate or a highlight that generates heat by heating a metal plate or a ceramic plate with a heating wire. As another example, the cooking appliance may include two or more of a working coil, a burner, a hot plate, and a highlight.

The heating device may further include a heating part case 15. The heating part case 15 may be formed in a polygonal shape having an open upper portion. An open upper portion of the heating part case 15 may be covered by the top plate 10, and various components constituting the heating device may be accommodated in an interior of the heating part case 15. In the present embodiment, a form in which components constituting the heating part 20, for example, a working coil, are accommodated in the interior of the heating part case 15 is exemplified.

As an example, the heating part case 15 may be formed in a rectangular box shape made of aluminum, but the shape and material of the heating part case 15 are not limited thereto. In addition, the heating part case 15 may be thermally insulated to suppress an increase in temperature of an outer surface of the heating part case 15 due to heat generated by the working coil.

The heating device may further include an electrical part 30. The electrical part 30 may include electrical components related to driving of the heating device, particularly the heating part 20. In the present embodiment, the electrical part 30 is exemplified as being disposed below the top plate 10, more specifically below the heating part case 15.

The electrical part 30 may include an electrical case 31. According to the present embodiment, the electrical case 31 may be formed in a polygonal shape having an open upper portion. An open upper portion of the electrical case 31 may be covered by the heating part case 15 or the top plate 10, and various electrical components may be accommodated in an interior of the electrical case 31.

As an example, at least one of the heating part case 15 and the electrical case 31 may be formed in a rectangular box shape made of aluminum, but the shapes and materials of the heating part case 15 and the electrical case 31 are not limited thereto. In addition, at least one of the heating part case 15 and the electrical case 31 may be thermally insulated to suppress an increase in temperature of an outer surface of the electrical case 31 due to heat generated by the working coil or the electrical components.

The cooking appliance including the heating device may be installed on a support 1. The support 1 is a structure for installing or fixing components of the cooking appliance, and may be provided in a predetermined cabinet structure. An interior of the support 1 may be formed with a space capable of accommodating at least a portion of the heating device and the exhaust device.

As an example, the support 1 may be provided in the form of kitchen furniture, more specifically, in the form of a lower cabinet. An upper portion of the support 1 provided in the form of kitchen furniture may be provided with a countertop 11. The heating device and the exhaust device may be installed on the countertop 11.

According to the present embodiment, only a portion of the heating device may be exposed above the countertop 11, and a remaining portion may be inserted into the support 1 so as to be disposed below the countertop 11. For example, the top plate 10 may be exposed above the countertop 11, and the heating part 20 may be disposed below the countertop 11.

As another example, the support 1 may be provided in the form of a cooking appliance including an oven. In this case, the heating device and the exhaust device installed on an upper surface of the support 1 may be disposed above a cooking chamber of the oven.

An opening 12 may be provided in the top plate 10. The opening 12 may form, in the top plate 10, a passage for opening the component arrangement space S toward the upper side of the top plate 10. The opening 12 may be formed in a hole shape penetrating the top plate 10 in an up-down direction.

The exhaust device may be disposed adjacent to the heating device. More specifically, the exhaust device may be disposed in a space below the top plate 10, that is, the component arrangement space S. The exhaust device is provided to collect smoke, vapor, contaminants, and the like generated around the exhaust device (hereinafter, collectively referred to as "contaminated air").

Contaminated air generated from the heating target seated on the top plate 10 may be collected into an interior of the exhaust device through the opening 12. The contaminated air collected into the interior of the exhaust device may be transferred to the interior of the support 1 through the interior of the exhaust device.

### [Overall Structure of the Exhaust Device]

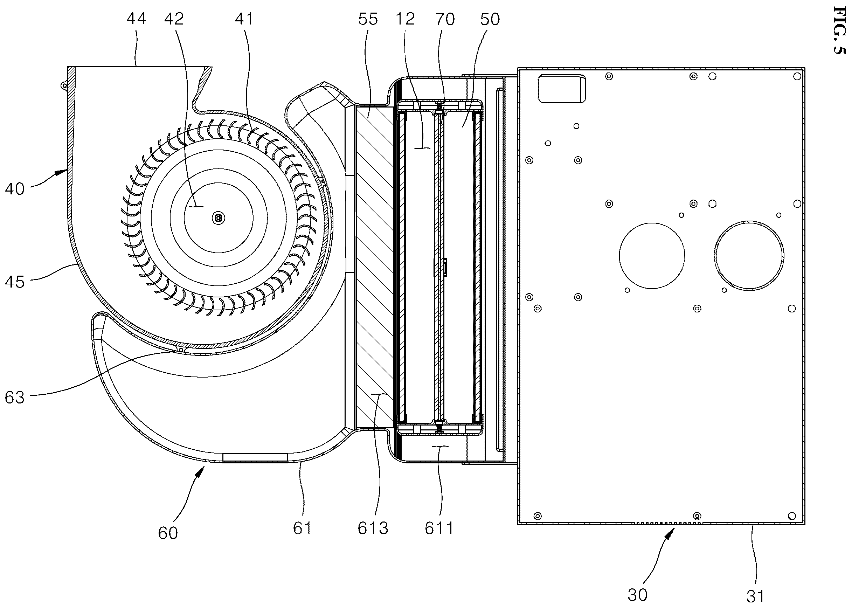

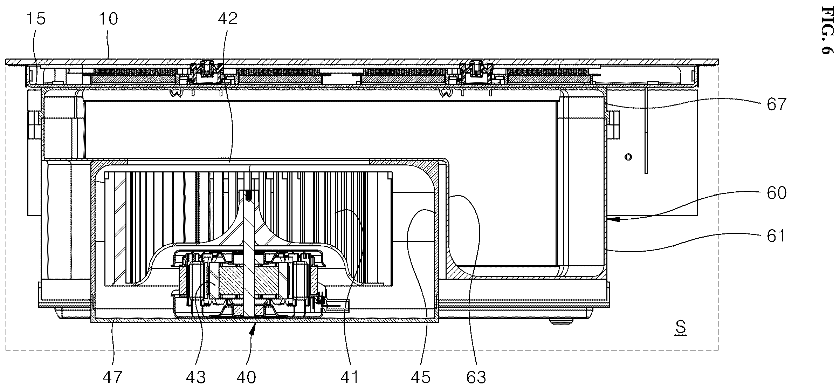

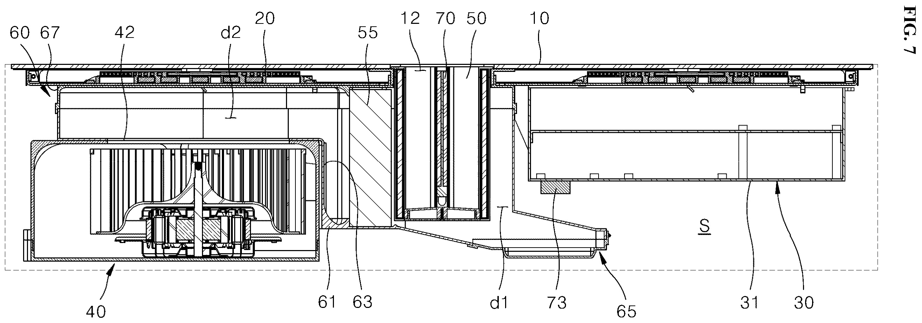

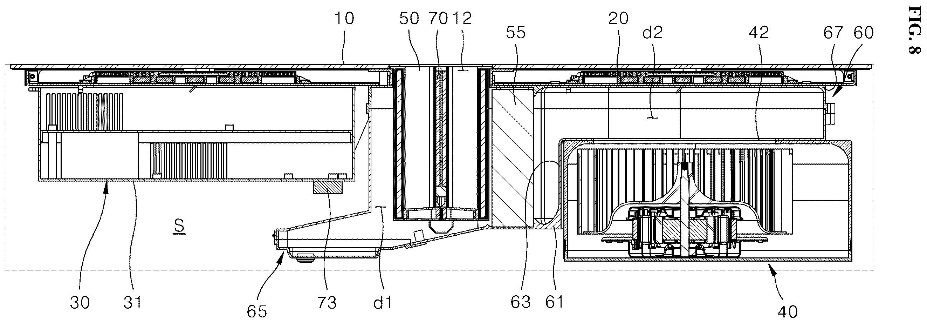

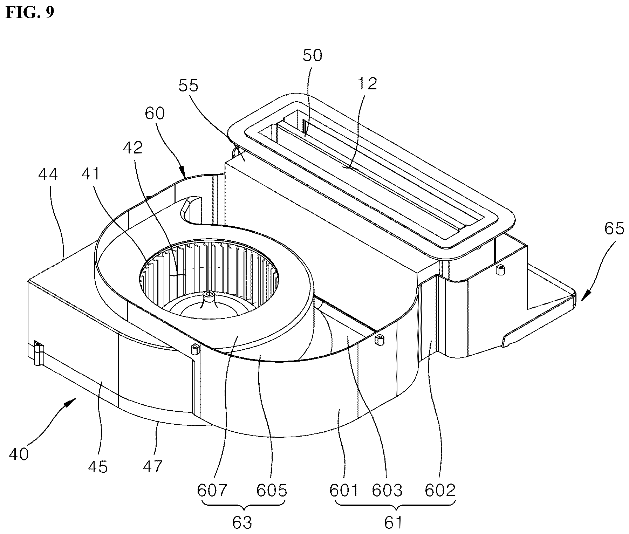

FIG. 5 is a plan sectional view showing an internal structure of the cooking appliance shown in FIG. 2, and FIG. 6 is a side sectional view showing an internal structure of the cooking appliance shown in FIG. 2. FIGS. 7 and 8 are front sectional views showing an internal structure of the cooking appliance shown in FIG. 2, and FIG. 9 is a perspective view showing an exhaust device shown in FIG. 2 in a disassembled state.

Referring to FIGS. 5 to 9, the exhaust device may include a fan 40. At least a portion of the fan 40 may be disposed in the component arrangement space S. The fan 40 may draw air above the top plate 10 through the opening 12. For example, the fan 40 disposed below the top plate 10 may draw contaminated air generated from the heating target seated on the top plate 10 through the opening 12.

Between the opening 12 and the fan 40, flow paths d1 and d2 for air flow may be formed. Air introduced into the component arrangement space S through the opening 12 may flow toward the fan 40 through the flow paths d1 and d2. For example, the opening 12 and an intake port 42 may be connected by the flow paths d1 and d2, and contaminated air outside the cooking appliance may be introduced into the flow paths d1 and d2 through the opening 12 and then flow toward the fan 40 through the flow paths d1 and d2.

The exhaust device may further include at least one filter 50 or 55. The filters 50 and 55 may be disposed in the component arrangement space S, and may be disposed between the opening 12 and the fan 40.

According to the present embodiment, at least a portion of the filters 50 and 55 may be disposed in the flow paths d1 and d2. For example, at least a portion of the filters 50 and 55 may be disposed between the opening 12 and the fan 40 in a horizontal direction.

The filters 50 and 55 may serve to filter contaminated air introduced into the flow paths d1 and d2 through the opening 12. Air introduced into the flow paths d1 and d2 through the opening 12 may pass through the filters 50 and 55, be filtered by the filters 50 and 55, and then flow toward the fan 40.

The exhaust device may further include a hood housing 60. The hood housing 60 is disposed in the component arrangement space S, and is provided to accommodate at least a portion of the fan 40 and at least a portion of the filters 50 and 55.

In addition, the flow paths d1 and d2 may be formed in an interior of the hood housing 60. Contaminated air outside the cooking appliance may be introduced into an interior of the hood housing 60 through the opening 12, and may flow toward the fan 40 through the flow paths d1 and d2 formed in the interior of the hood housing 60.

### [Fan]

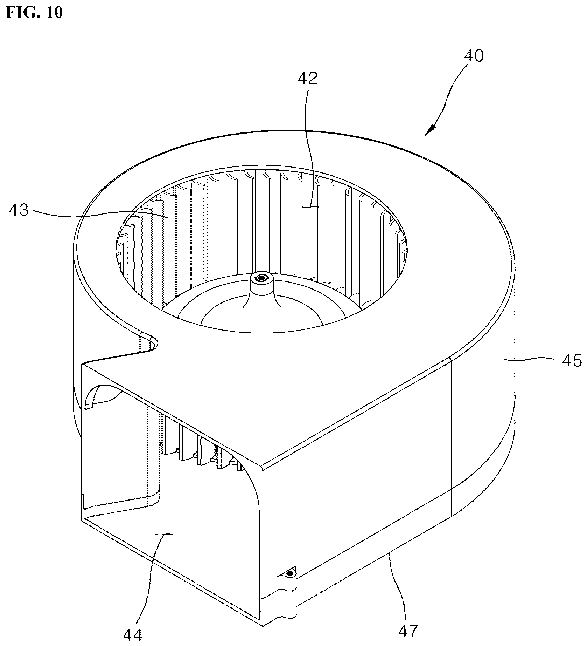

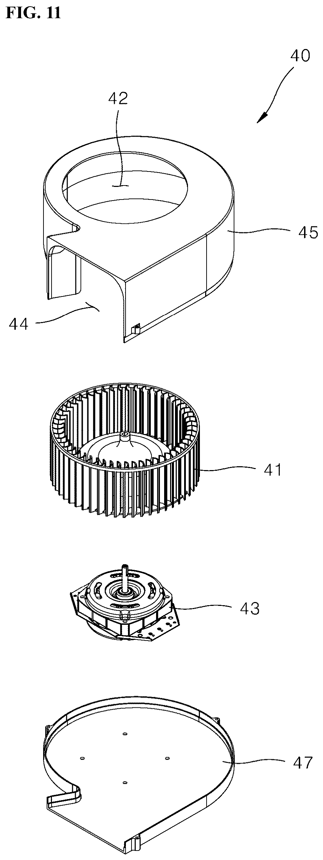

FIG. 10 is a perspective view showing the fan shown in FIG. 9 in a disassembled state, and FIG. 11 is an exploded perspective view showing an exploded state of the fan shown in FIG. 10.

Referring to FIGS. 7 to 11, the fan 40 may be installed in the hood housing 60, and at least a portion of the fan 40 may be accommodated in the hood housing 60. The fan 40 may include an impeller 41 and a fan motor 43.

According to the present embodiment, the impeller 41 may be provided to rotate about a vertical direction axis, for example, a vertical axis. An interior of the impeller 41 is formed with a space portion, and air drawn by the impeller 41 may be introduced into the space portion.

The impeller 41 may be connected to a rotation shaft of the fan motor 43. A rotation shaft of the fan motor 43 rotates about a vertical axis, and the impeller 41 connected to the rotation shaft of the fan motor 43 may be rotated about the vertical axis.

As an example, the fan 40 may be provided in the form of a centrifugal fan. For example, the fan 40 may be provided in the form of a scroll fan. In addition, an intake port 42 may be provided at at least one of an upper end and a lower end of the fan 40. The fan 40 may draw air in a vertical direction through the intake port 42, and may discharge the drawn air in a horizontal direction.

According to the present embodiment, the intake port 42 may be provided in the fan 40 and may be disposed on a side facing the top plate 10. As an example, the intake port 42 may be disposed at the upper portion of the fan 40 to open an interior of the fan 40 upward. For example, the intake port 42 may be provided at an upper end of the fan 40 to open the space portion inside the impeller 41 upward.

The fan 40 may draw air introduced into the component arrangement space S through the opening 12, and may draw air above the fan 40 through the intake port 42. The fan 40 that draws air through the intake port 42 in this manner may discharge the air in a direction different from a direction in which the intake port 42 opens the interior of the fan 40. For example, the fan 40 may draw air in a vertical direction through the intake port 42 and may discharge the drawn air in a horizontal direction.

The fan 40 may further include a fan housing 45. The fan housing 45 forms an outer appearance of the fan 40 and may accommodate the impeller 41 therein.

In the present embodiment, the fan housing 45 is exemplified as being formed in a scroll shape. A space for accommodating the impeller 41 may be formed in an interior of the fan housing 45. An inner circumferential surface of the fan housing 45 facing the internal space may be formed as a curved surface surrounding an outer circumferential surface of the impeller 41.

An intake port 42 may be formed at an upper portion of the fan housing 45. The intake port 42 may form, in the fan housing 45, a passage required for air outside the fan 40 to be drawn into an interior of the impeller 41.

In addition, an exhaust port 44 may be provided in the fan housing 45. The exhaust port 44 forms a passage required for air drawn into the interior of the fan housing 45 by the impeller 41 to be discharged to the outside of the fan 40.

The exhaust port 44 may be formed in a shape penetrating the fan housing 45 in a horizontal direction. Accordingly, air drawn into the interior of the fan 40 in a vertical direction through the intake port 42 may be discharged from the fan 40 in a horizontal direction through the exhaust port 44.

As an example, the exhaust port 44 may be disposed at a rear portion of the fan housing 45. In this case, air drawn into the fan 40 may be discharged rearward and may be discharged to the outside of the cooking appliance through a rear portion of the cooking appliance.

As another example, the exhaust port 44 may be disposed at a side portion of the fan housing 45. In this case, air drawn into the fan 40 may be discharged laterally and may be discharged to the outside of the cooking appliance through a side portion of the cooking appliance.

As described above, the impeller 41 is accommodated in the internal space of the fan housing 45, and the internal space of the fan housing 45 may be exposed downward through an open lower portion of the fan housing 45.

According to the present embodiment, the fan 40 may further include a fan base 47. The fan base 47 may be disposed below the fan housing 45 and may be provided to cover a lower portion of the fan housing 45 from below the fan housing 45.

The fan base 47 may be coupled to a lower portion of the fan housing 45. In addition, the fan base 47 may support the fan motor 43 from below. The fan base 47 may be coupled to a lower portion of the fan motor 43 and a lower portion of the fan housing 45 to support the fan motor 43 on the fan housing 45.

As an example, the fan 40 may be configured to include the impeller 41, the fan motor 43, the fan housing 45, and the fan base 47, and each of the components may be detachably assembled.

The fan base 47 may be detachably coupled to the fan housing 45. When the fan base 47 is separated from the fan housing 45, an internal space of the fan housing 45 is opened downward. In this case, the impeller 41 and the fan motor 43 accommodated in the internal space of the fan housing 45 become withdrawable to the outside of the fan housing 45 through an opened lower portion of the fan housing 45.

An upper side of the fan 40 is covered by the top plate 10, and a space between the fan 40 and the top plate 10, particularly a space between the hood housing 60 and the top plate 10, is considerably narrow. Accordingly, withdrawing the impeller 41 and the fan motor 43 to the outside of the fan housing 45 through an upper portion of the fan housing 45 is not easy.

To enable such upward withdrawal, a sufficient space may need to be secured between the hood housing 60 and the top plate 10, which may increase a vertical length of the cooking appliance and may cause an overall size thereof to be unnecessarily increased.

In consideration of this, in the present embodiment, a lower side of the component arrangement space S is formed in an open structure without being covered, and the fan base 47 is provided to open a lower portion of the fan housing 45. This structure allows the impeller 41 and the fan motor 43, which are main components of the fan 40, to be withdrawn to the outside through a lower portion of the cooking appliance. Accordingly, it is possible to effectively improve maintainability and accessibility of the fan 40 without increasing an overall external size of the cooking appliance.

In the present embodiment, a form in which the fan housing 45 is formed as a separate member distinct from the hood housing 60 is exemplified. As another example, the fan housing 45 may be formed integrally with the hood housing 60.

In this case as well, the fan base 47 may be provided as a separate component separated from the fan housing 45, and may be detachably coupled to a lower portion of the fan housing 45. Accordingly, even in a structure in which the fan housing 45 is formed integrally with the hood housing 60, by separating the fan base 47, a maintenance advantage of allowing the impeller 41 and the fan motor 43 to be withdrawn downward may be equally provided.

### [Filter]

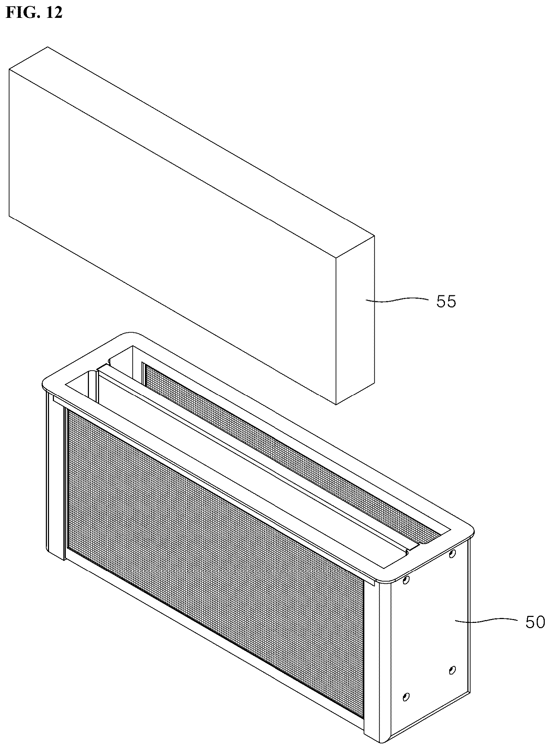

FIG. 12 is a view showing the filter shown in FIG. 9 in a disassembled state.

According to the present embodiment, as illustrated in FIGS. 8, 9, and 12, at least a portion of the filters 50 and 55 may be disposed in the flow paths d1 and d2. For example, flow paths d1 and d2 may be formed in the interior of the hood housing 60, and at least a portion of the filters 50 and 55 may be accommodated in the interior of the hood housing 60.

The exhaust device of the present embodiment may include a plurality of filters 50 and 55. As an example, the exhaust device may include a first filter 50 and a second filter 55.

The first filter 50 may be disposed in the component arrangement space S. For example, the first filter 50 may be disposed between the opening 12 and the fan 40.

In addition, the first filter 50 may be disposed in the interior of the hood housing 60 and may be disposed on the flow paths d1 and d2. The first filter 50 may be installed in a region through which contaminated air first passes inside the exhaust device.

The first filter 50 may be provided for a purpose of primarily purifying contaminated air containing grease. As an example, the first filter 50 may be provided as a grease filter.

The first filter 50 may be formed in a porous structure. The first filter 50 may be provided as a filter having a structure that effectively collects grease or large particulate contaminants while not obstructing a flow of air.

An upper portion of the first filter 50 is opened upward toward the opening 12, and a space capable of temporarily retaining contaminated air may be formed in an interior of the first filter 50. Contaminated air flowing downward from the opening 12 toward the interior of the first filter 50 temporarily stays in the interior of the first filter 50 and then passes through the first filter 50 in a horizontal direction.

Contaminated air introduced from the opening 12 into the interior of the first filter 50 comes into contact with wall surfaces of the first filter 50 while temporarily staying in the interior of the first filter 50. When contaminated air comes into contact with wall surfaces of the first filter 50 in the interior of the first filter 50, grease or large particulate contaminants in the contaminated air adhere to or are deposited on the wall surfaces of the first filter 50 and are separated from the contaminated air. Air from which grease or large particulate contaminants are removed in this manner passes through the first filter 50.

Like the first filter 50, the second filter 55 may be disposed in the interior of the hood housing 60 and may be disposed on the flow paths d1 and d2. The second filter 55 may be disposed between the first filter 50 and the fan 40. The second filter 55 may be disposed between the first filter 50 and the fan 40.

The second filter 55 may be provided as a filter for additionally purifying contaminated air that has passed through the first filter 50. As an example, the second filter 55 may be a charcoal filter.

The second filter 55 may perform a role of removing gaseous contaminants such as residual odor components and volatile organic compounds (VOCs) remaining in contaminated air that has been primarily purified by the first filter 50. Accordingly, the second filter 55 may improve cleanliness of air finally discharged to an outside of the exhaust device.

The first filter 50 and the second filter 55 may be sequentially arranged at positions spaced apart from each other on air flow paths, that is, flow paths d1 and d2. In addition, their arrangement may be set such that the first filter 50 is positioned upstream and the second filter 55 is positioned downstream along a flow direction of contaminated air. Accordingly, each of the filters 50 and 55 may improve overall contaminant removal efficiency by performing complementary purification functions with each other.

### [Hood Housing]

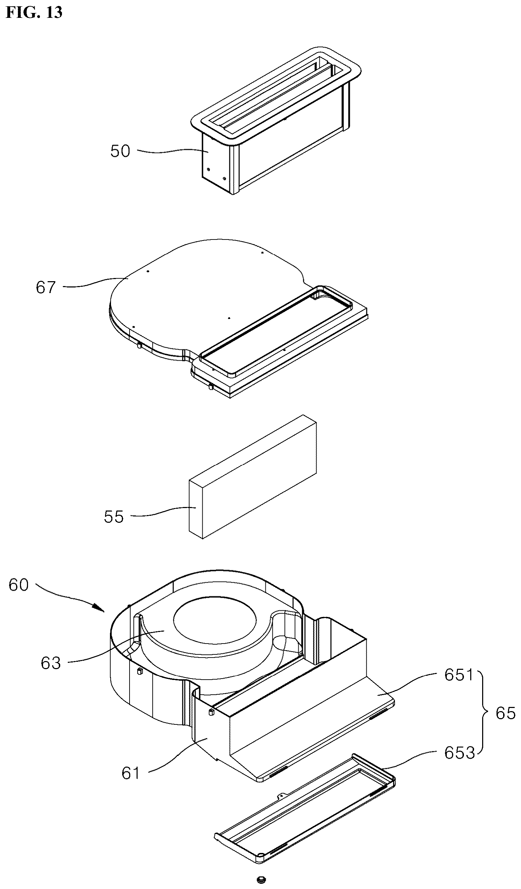

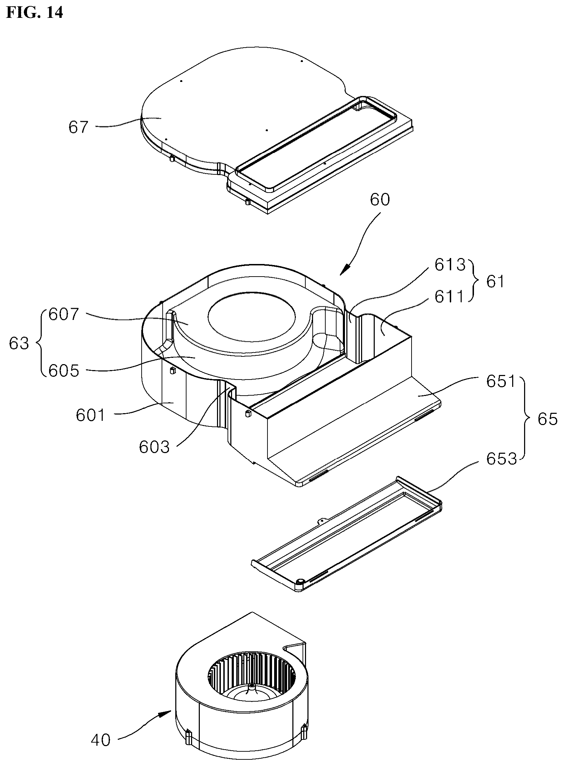

FIG. 13 is a perspective view showing an exploded state of the exhaust device shown in FIG. 9, and FIGS. 14 and 15 are perspective views showing an exploded state of a hood housing and a fan housing shown in FIG. 13.

Referring to FIGS. 8 to 9 and FIGS. 13 to 14, the filters 50 and 55 may be accommodated in the hood housing 60. The hood housing 60 is provided to accommodate at least a portion of the fan 40 and the first filter 50 and the second filter 55.

The hood housing 60 may include an outer wall portion 601 and a bottom portion 603. The outer wall portion 601 and the bottom portion 603 are provided to form an exterior of the hood housing 60.

The outer wall portion 601 may define an outer boundary surface of the hood housing 60 in a horizontal direction, and the bottom portion 603 may define an outer boundary surface in a vertical direction. For example, the outer wall portion 601 may form a front surface, a rear surface, and both side surfaces of the hood housing 60, and the bottom portion 603 may form a bottom surface of the hood housing 60.

In addition, a space for accommodating the fan 40 and the filters 50 and 55 may be formed inside the hood housing 60, and a portion of the hood housing 60 may be open upward.

According to the present embodiment, the hood housing 60 may include a flow path forming portion 61. The flow path forming portion 61 may be disposed between the opening 12 and the fan 40, and flow paths d1 and d2 may be formed inside the flow path forming portion 61. That is, flow paths d1 and d2 are formed inside the flow path forming portion 61, and the flow paths d1 and d2 may connect the opening 12 and the fan 40.

The flow path forming portion 61 may include filter accommodating portions 611 and 613. A space for accommodating the filters 50 and 55 may be formed in the filter accommodating portions 611 and 613. For example, the flow path forming portion 61 may include a first filter accommodating portion 611 for accommodating the first filter 50 and a second filter accommodating portion 613 for accommodating the second filter 55.

The first filter accommodating portion 611 is provided to accommodate the first filter 50, and the second filter accommodating portion 613 is provided to accommodate the second filter 55. On an air flow path, the first filter accommodating portion 611 may be disposed between the opening 12 and the fan 40, and the second filter accommodating portion 613 may be disposed between the first filter accommodating portion 611 and the fan 40.

In addition, in a horizontal direction, the second filter accommodating portion 613 may be disposed between the first filter accommodating portion 611 and the fan 40. The first filter accommodating portion 611 and the second filter accommodating portion 613 may be connected in a horizontal direction. For example, the second filter accommodating portion 613 may be disposed on a right side of the first filter accommodating portion 611, the fan 40 may be disposed on a right side of the second filter accommodating portion 613, and the first filter accommodating portion 611 and the second filter accommodating portion 613 may be connected in a left-right direction.

A first flow path d1 may be formed inside the first filter accommodating portion 611 and the second filter accommodating portion 613 that are connected in a horizontal direction as described above. The first flow path d1 may be open toward the opening 12 in the first filter accommodating portion 611 and open toward the fan 40 in the second filter accommodating portion 613. For example, the first flow path d1 may be open upward in the first filter accommodating portion 611 and open rightward in the second filter accommodating portion 613.

The first filter 50 may be disposed in the first flow path d1 in the first filter accommodating portion 611, and the second filter 55 may be disposed in the first flow path d1 in the second filter accommodating portion 613. The first flow path d1 may be connected to the opening 12, and contaminated air outside the cooking appliance may be introduced into the first flow path d1 through the opening 12. Air introduced into the first flow path d1 as described above may flow toward the fan 40 after sequentially passing through the first filter 50 accommodated in the first filter accommodating portion 611 and the second filter 55 accommodated in the second filter accommodating portion 613.

The first filter accommodating portion 611 and the second filter accommodating portion 613 may be partitioned by a partition wall 602. The partition wall 602 may be a portion of the outer wall portion 601. More specifically, at least a portion of a region of the outer wall portion 601 disposed between the first filter accommodating portion 611 and the second filter accommodating portion 613 may be formed as the partition wall 602. The partition wall 602 may be formed as a vertical wall surface in which a portion of the outer wall portion 601 protrudes toward an inside of the hood housing 60 in a horizontal direction.

For example, a pair of partition walls 602 may be disposed between the first filter accommodating portion 611 and the second filter accommodating portion 613 in a front-rear direction. For example, one of the pair of partition walls 602 may be formed such that a portion of a front surface of the outer wall portion 601 protrudes rearward toward an inside of the hood housing 60. The other one of the pair of partition walls 602 may be formed such that a portion of a rear surface of the outer wall portion 601 protrudes forward toward an inside of the hood housing 60.

A connection hole 612 may be formed between the first filter accommodating portion 611 and the second filter accommodating portion 613. The connection hole 612 may form a passage connecting the first filter accommodating portion 611 and the second filter accommodating portion 613. Air that has been introduced into the first flow path d1 and has passed through the first filter 50 may flow toward the second filter 55 by passing through the connection hole 612.

For example, the connection hole 612 may be formed to penetrate between the first filter accommodating portion 611 and the second filter accommodating portion 613 in a left-right direction. The connection hole 612 may be disposed between the first filter accommodating portion 611 and the second filter accommodating portion 613 in a left-right direction, and may be disposed between the pair of partition walls 602 in a front-rear direction.

The connection hole 612 may connect an inside of the first filter accommodating portion 611 and an inside of the second filter accommodating portion 613 in a horizontal direction, and may be formed such that the second filter 55 may pass through the connection hole 612 in the horizontal direction. That is, the connection hole 612 may form a passage required for the second filter 55 to move from the first filter accommodating portion 611 to the second filter accommodating portion 613 through the connection hole 612.

Both the first filter 50 and the second filter 55 may be inserted into an inside of the hood housing 60 through the opening 12. The second filter 55 may be moved downward through the opening 12 and inserted into the first filter accommodating portion 611, and thereafter may be moved in a horizontal direction and inserted into the second filter accommodating portion 613. In this manner, after the second filter 55 is first inserted into the inside of the hood housing 60, the first filter 50 may be inserted into the inside of the hood housing 60 through the opening 12, whereby assembly of the first filter 50 and the second filter 55 may be performed sequentially.

According to the present embodiment, a width of the second filter 55 may be set to be smaller than a width of the first filter 50. In the present embodiment, a "front-rear direction length" of the first filter 50 or the second filter 55 is defined as a "width" of the first filter 50 or the second filter 55.

A width of the first filter 50 may be set to be equal to or smaller than a width of the first filter accommodating portion 611. A width of the connection hole 612 may be set to be equal to or greater than the width of the second filter 55 and smaller than the width of the first filter 50. Accordingly, the second filter 55 may move from the first filter accommodating portion 611 to the second filter accommodating portion 613 through the connection hole 612, whereas the first filter 50 is prevented from passing through the connection hole 612.

That is, the second filter 55 may easily move from the first filter accommodating portion 611 to the second filter accommodating portion 613 by passing through a region in which the partition wall 602 is disposed, whereas the first filter 50 is caught by the partition wall 602 in the first filter accommodating portion 611 and thus cannot move to the second filter accommodating portion 613. Accordingly, the first filter 50 and the second filter 55 may be clearly installed at different positions separated from each other.

The hood housing 60 may further include a fan accommodating portion 63. The fan accommodating portion 63 is provided to accommodate at least a portion of the filters 50 and 55. At least a portion of the fan accommodating portion 63 may be accommodated inside the flow path forming portion 61.

According to the present embodiment, the flow path forming portion 61 may be disposed within a space surrounded by the outer wall portion 601 and the bottom portion 603 of the hood housing 60. That is, an outer boundary surface of the flow path forming portion 61 in a horizontal direction may be defined by the outer wall portion 601, and a bottom surface of the flow path forming portion 61 may be defined by the bottom portion 603.

Similarly to the flow path forming portion 61, the fan accommodating portion 63 may be disposed within a space surrounded by the outer wall portion 601. That is, the fan accommodating portion 63 may be disposed inside the hood housing 60, and the flow path forming portion 61 may accommodate at least a portion of the fan accommodating portion 63 therein. In addition, at least a portion of the fan 40 may be accommodated in the fan accommodating portion 63 and disposed inside the hood housing 60.

The fan accommodating portion 63 may include an inner wall portion 605 surrounding the fan 40 from a horizontal outer side. More specifically, the fan accommodating portion 63 may be formed in a shape of a vertical wall surface surrounding an intake port 42 from a horizontal outer side. For example, the inner wall portion 605 may be formed in a substantially cylindrical wall surface shape protruding upward from the bottom portion 603 of the hood housing 60.

In addition, the fan accommodating portion 63 may further include an upper surface portion 607. The upper surface portion 607 may be disposed above the inner wall portion 605 and may form an upper surface of the fan accommodating portion 63. For example, the upper surface portion 607 may be formed in a ring shape covering an upper portion of the inner wall portion 605. A hollow penetrating the upper surface portion 607 in a vertical direction may be formed inside the upper surface portion 607, and the intake port 42 may be open upward through the hollow.

According to the present embodiment, an upper end of the inner wall portion 605 and the upper surface portion 607, that is, an upper end of the fan accommodating portion 63, may be disposed between the intake port 42 and the top plate 10. A second flow path d2 connecting the first flow path d1 and the intake port 42 may be formed between the upper end of the fan accommodating portion 63 and the top plate 10. Air that has passed through the first filter 50 and the second filter 55 in the first flow path d1 may pass through the intake port 42 via the second flow path d2 and be drawn into the fan 40.

The second flow path d2 may be disposed above the fan 40 and the intake port 42. That is, air that has passed through the first filter 50 and the second filter 55 in the first flow path d1 may be introduced into an inside of the fan 40 through a flow path formed above the fan 40 and the intake port 42.

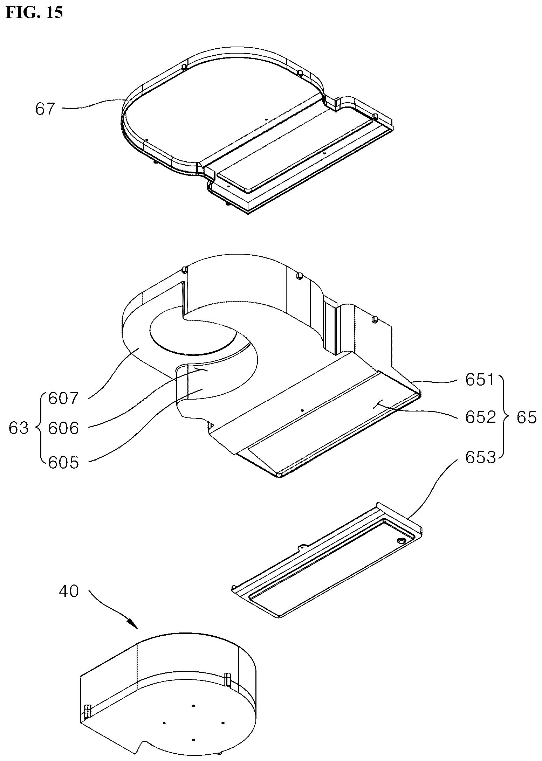

When viewed from below, as illustrated in FIGS. 8 and 15, the fan accommodating portion 63 may have a shape recessed upward from a bottom surface of the hood housing 60. That is, a space 606 (hereinafter, referred to as a "fan accommodating space") formed as a result of a portion of the bottom portion 603 being recessed upward may be formed in the fan accommodating portion 63, and at least a portion of the fan 40 may be inserted into the fan accommodating space 606.

When the fan housing 45 is inserted into the fan accommodating space 606, at least a portion of an upper surface of the fan housing 45 may be in contact with the upper surface portion 607 from below, and at least portions of a front surface, a rear surface, and side surfaces of the fan housing 45 may be in contact with the inner wall portion 605.

In addition, at least a portion of a rear portion of the fan accommodating space 606 may be open rearward, and the exhaust port 44 may be exposed to an outside of the fan housing 45 through the rear portion of the fan accommodating space 606 opened in this manner.

For example, the fan housing 45 may be provided as a separate member from the hood housing 60. For example, the fan housing 45 may be coupled to the hood housing 60 in a state in which at least a portion of the fan housing 45 is inserted into the fan accommodating portion 63.

As another example, the fan housing 45 may be formed integrally with the hood housing 60. In this case, the fan housing 45 may be provided in the hood housing 60 in a form replacing the fan accommodating portion 63, or the fan accommodating portion 63 provided in the hood housing 60 may be formed in a shape corresponding to a shape of the fan housing 45.

Meanwhile, the exhaust device may further include a housing cover 67. The housing cover 67 is provided to cover an open upper portion of the hood housing 60. In a vertical direction, the housing cover 67 may be disposed between the top plate 10 and the hood housing 60, more specifically, between the heating part case 15 and the hood housing 60.

The housing cover 67 may cover an upper portion of the hood housing 60 and be coupled to an upper end of the outer wall portion 601, and the flow paths d1 and d2 may be formed in a space surrounded by the hood housing 60 and the housing cover 67.

According to the present embodiment, the housing cover 67 may form an upper boundary surface of the first flow path d1 and the second flow path d2. The first filter 50 and the second filter 55 disposed in the first flow path d1 are accommodated in a space covered by the housing cover 67. A lower boundary surface of the second flow path d2 is defined by the upper surface portion 607 of the fan accommodating portion 63, and an upper boundary surface of the second flow path d2 is defined by the housing cover 67.

The second flow path d2 is a flow path formed above the fan 40 and may be defined as a space formed between the intake port 42 of the fan 40 and the housing cover 67.

As another example, without the housing cover 67, the hood housing 60 and the heating part case 15 may be directly coupled to each other. For example, the heating part case 15 may cover an upper portion of the hood housing 60 and be coupled to an upper end of the outer wall portion 601, and the flow paths d1 and d2 may be formed in a space surrounded by the hood housing 60 and the heating part case 15.

In addition, an opening may be formed in the housing cover 67. The opening may be formed in a shape corresponding to an opening formed in the top plate 10 and may be disposed to communicate with the opening 12. The opening may form, in the housing cover 67, a passage connecting the opening 12 of the top plate 10 and the flow paths d1 and d2.

### [Fluid Collection part]

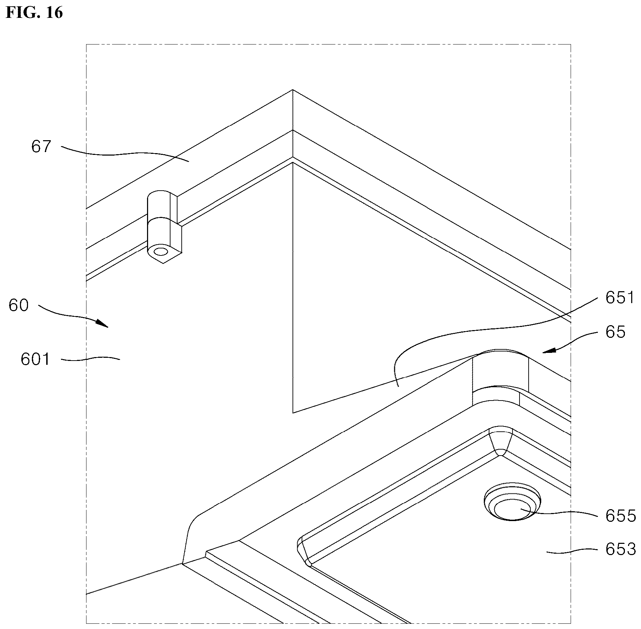

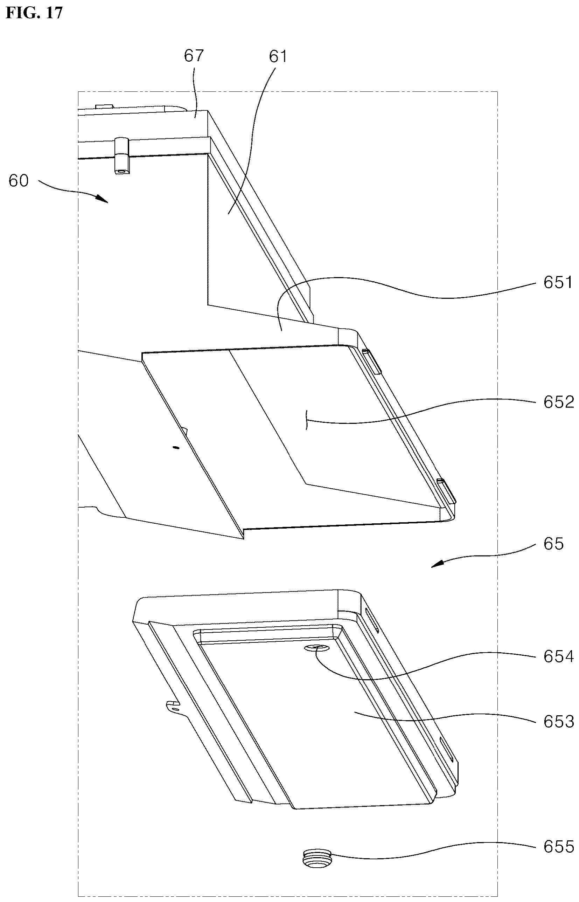

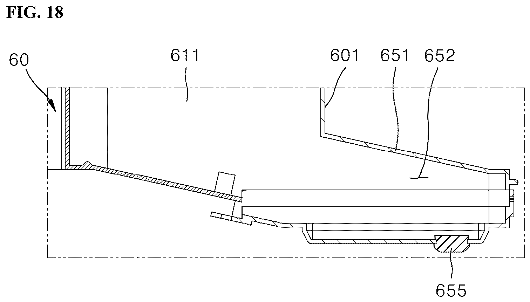

FIG. 16 is a view showing an enlarged portion of the exhaust device shown in FIG. 9, FIG. 17 is an exploded perspective view showing an exploded state of a fluid collection part shown in FIG. 16, and FIG. 18 is a front sectional view showing an internal structure of the fluid collection part shown in FIG. 16.

Referring to FIGS. 8 and 16 to 18, the exhaust device of the present embodiment may further include a fluid collection part 65. The fluid collection part 65 is provided to collect fluid separated from air by the filters 50 and 55. More specifically, the fluid collection part 65 is provided as a structure for collecting liquid fluid (hereinafter referred to as "liquid fluid") such as oil components falling from contaminated air passing through the first filter 50.

The fluid collection part 65 may be disposed to be spaced apart from the fan 40 in a horizontal direction with the opening 12 interposed therebetween. The fan 40 and the fluid collection part 65 may be disposed to be spaced apart from each other in a horizontal direction with the filters 50 and 55 interposed therebetween.

According to the present embodiment, at least a portion of the filters 50 and 55 may be disposed in the flow paths d1 and d2. More specifically, the filters 50 and 55 may be disposed in the first flow path d1. The fluid collection part 65 may be disposed outside the flow paths d1 and d2. The fluid collection part 65 may be disposed to be spaced apart from the fan 40 in a horizontal direction with the flow paths d1 and d2 interposed therebetween.

Air introduced into the first flow path d1 through the opening 12 may be filtered by the filters 50 and 55. Liquid fluid filtered by the first filter 50 may flow out to an outside of the flow paths d1 and d2 and be collected in the fluid collection part 65.

For example, the fan 40 may be disposed on a left side of the opening 12 and the filters 50 and 55, and the fluid collection part 65 may be disposed on a right side of the opening 12 and the filters 50 and 55. In this case, contaminated air introduced through the opening 12 may flow leftward toward the second filter 55 and the fan 40 after passing through the first filter 50, and liquid fluid filtered by the first filter 50 may be collected in the fluid collection part 65 disposed on a right side of the filters 50 and 55.

The fluid collection part 65 may be provided to be connected to the hood housing 60. The fluid collection part 65 may be connected to the flow path forming portion 61 such that an internal space of the fluid collection part 65 communicates with an internal space of the flow path forming portion 61. More specifically, the fluid collection part 65 may be connected to the flow path forming portion 61 such that an internal space of the fluid collection part 65 communicates with the first flow path d1.

The fluid collection part 65 may be disposed to be spaced apart from the fan 40 in a horizontal direction with the flow path forming portion 61 interposed therebetween. The fluid collection part 65 may be formed in a shape protruding from the flow path forming portion 61 in a horizontal direction. For example, the fluid collection part 65 may be formed in a shape protruding in a direction away from the fan 40.

According to the present embodiment, the fluid collection part 65 may include a collection protrusion portion 651. The collection protrusion portion 651 may be provided in a shape protruding laterally from the first filter accommodating portion 611. For example, the collection protrusion portion 651 may be integrally formed with the flow path forming portion 61. For example, the hood housing 60 may be provided in a form in which the flow path forming portion 61, the fan accommodating portion 63, and the collection protrusion portion 651 are integrally formed.

A collecting space 652 may be formed inside the collection protrusion portion 651. The collecting space 652 may communicate with the first filter accommodating portion 611 and may communicate with the first flow path d1. Liquid fluid separated from the first filter 50 may be introduced from the first flow path d1 into the collecting space 652.

For example, an upper surface of the collection protrusion portion 651 may be formed to be inclined. For example, an upper surface of the collection protrusion portion 651 may be formed as an inclined surface that gradually decreases in height toward a horizontal outer side from the flow path forming portion 61 or the filters 50 and 55.

According to the present embodiment, an upper surface of the collection protrusion portion 651 may be connected to the outer wall portion 601, and may be formed to be connected to a portion of the outer wall portion 601 disposed at the first filter accommodating portion 611. The upper surface of the collection protrusion portion 651 may be formed in an inclined shape such that a height thereof gradually decreases as the upper surface extends away from the outer wall portion 601 in a lateral direction.

Liquid fluid contained in contaminated air introduced into the first filter accommodating portion 611 may be filtered by the first filter 50, and some of liquid fluid not filtered by the first filter 50 may adhere to the outer wall portion 601. Liquid fluid adhering to the outer wall portion 601 as described above may flow downward along the outer wall portion 601 and reach the upper surface of the collection protrusion portion 651.

Since the upper surface of the collection protrusion portion 651 is formed to be inclined, liquid fluid that has reached the upper surface of the collection protrusion portion 651 may naturally flow downward. Liquid fluid flowing downward in this manner may be efficiently collected inside the fluid collection part 65.

That is, by forming the upper surface of the collection protrusion portion 651 as an inclined surface, liquid fluid adhering to the outer wall portion 601 may be naturally guided toward the collecting space 652 by gravity. Accordingly, a phenomenon in which fluid accumulates at arbitrary positions or flows and spreads contamination may be suppressed.

In addition, the fluid collection part 65 may include a collection tray 653. The collection tray 653 may be disposed below the collection protrusion portion 651 and may be coupled to a lower portion of the collection protrusion portion 651.

According to the present embodiment, an opening may be formed in a lower portion of the collection protrusion portion 651, and liquid fluid introduced into the collecting space may fall through the opening into the collection tray 653 and be collected on a bottom surface of the collection tray 653. For example, the collection tray 653 may be formed of a metal material or a synthetic resin material having high contamination resistance.

By providing the collecting space 652 and the collection tray 653 to communicate with each other, liquid fluid may be concentrated and collected in the collection tray 653 without remaining at a specific portion. As a result, contamination accumulation inside the hood housing 60 may be reduced.

The collection tray 653 is provided to be insertable into or coupled to a lower portion of the collection protrusion portion 651. The collection tray 653 may be provided in a detachable form with respect to the collection protrusion portion 651.

For example, the collection tray 653 may be detachably coupled to the collection protrusion portion 651 by using a locking step structure. For example, a protrusion may be formed on an upper end of the collection tray 653, and a corresponding groove for receiving the protrusion may be formed in the collection protrusion portion 651. When a user inserts the protrusion into the groove, the collection tray 653 may be fixed to the collection protrusion portion 651, and when the user removes the protrusion from the groove, the collection tray 653 may be separated.

As another example, the collection tray 653 may be detachably coupled to the collection protrusion portion 651 by using a slide rail structure. For example, rail portions may be formed on both side surfaces of the collection tray 653, and guide rails corresponding thereto may be formed in the collection protrusion portion 651. In this case, insertion and removal of the collection tray 653 may be performed by pushing and pulling the collection tray 653 in a front-rear direction or a left-right direction.

As another example, the collection tray 653 may be detachably coupled to the collection protrusion portion 651 by using a magnetic structure. For example, a magnet may be embedded in the collection tray 653 or a magnetic material may be included in the collection tray 653, and a magnetizable metal material may be provided in the collection protrusion portion 651. In this case, the collection tray 653 may be attached to the collection protrusion portion 651 by magnetic force.

As the collection tray 653 is provided to be detachable as described above, convenience of maintenance may be effectively improved in that a user may easily separate the collection tray 653 to empty collected fluid or to clean or replace the collection tray 653 without greatly increasing a disassembly range of the cooking appliance.

Meanwhile, a discharge hole 654 may be formed in the collection tray 653. The discharge hole 654 may be disposed on a bottom surface of the collection tray 653 in which liquid fluid accumulates and may be formed to penetrate the bottom surface of the collection tray 653 in a vertical direction.

Preferably, at least a portion of the bottom surface of the collection tray 653 may be formed to be inclined downward toward the discharge hole 654. Accordingly, liquid fluid that has fallen into the collection tray 653 may gather at and around the discharge hole 654 and may be easily discharged to an outside of the fluid collection part 65 through the discharge hole 654.

In addition, the fluid collection part 65 may further include a cap 655. The cap 655 is provided to open and close the discharge hole 654. A user may separate the cap 655 from the collection tray 653 to easily discharge liquid fluid from the fluid collection part 65, and may couple the cap 655 to the collection tray 653 to close the discharge hole 654.

According to the present embodiment, by disposing the fluid collection part 65 below the electrical part 30, a free space below the electrical part 30 may be utilized as an installation space for the fluid collection part 65, and the free space below the electrical part 30 may be utilized to secure a fluid collection capacity. Accordingly, a sufficient fluid collection capacity may be secured even in a limited component arrangement space S.

That is, the cooking appliance according to the present embodiment may efficiently increase a fluid collection capacity of the fluid collection part 65 by sufficiently securing a horizontal length of the fluid collection part 65, thereby effectively preventing excessive accumulation or leakage of fluid and reducing user inconvenience caused by frequent emptying operations.

### [Arrangement Structure of Fan, Filters, Fluid Collection part, and Electrical part]

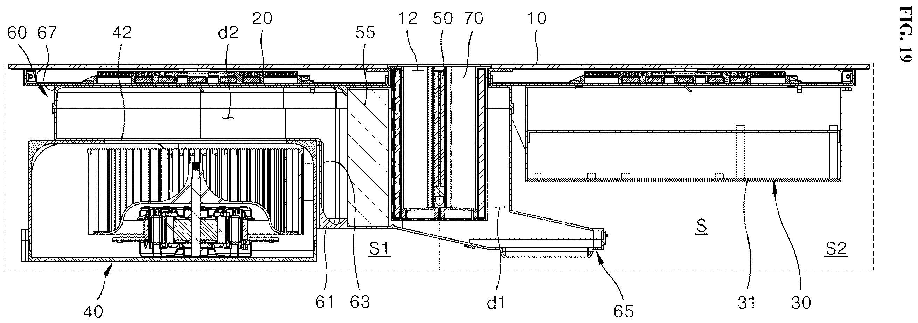

FIG. 19 is a front sectional view showing a component arrangement state in a component arrangement space.

As illustrated in FIG. 19, the opening 12 may be disposed between the fan 40 and the electrical part 30. That is, the fan 40 and the electrical part 30 may be disposed to be spaced apart from each other in a horizontal direction with the opening 12 interposed therebetween. In the present embodiment, the fan 40 and the electrical part 30 are exemplified as being disposed to be spaced apart from each other in a left-right direction with the opening 12 interposed therebetween.

According to the present embodiment, a component arrangement space S (see FIG. 7) may be divided into two divided spaces arranged in a left-right direction. One of the two divided spaces may be used as a space for accommodating components involved in flow of contaminated air introduced through the opening 12, and the other one of the two divided spaces may be used as a space for accommodating electrical components not involved in suction and discharge of contaminated air.

For example, in one of the divided spaces S1 (hereinafter referred to as a "first space") disposed on either a left side or a right side of the opening 12, the fan 40 and the filters 50 and 55 may be disposed, and in the other one of the divided spaces S2 (hereinafter referred to as a "second space") disposed on the other one of the left side or the right side of the opening 12, the electrical part 30 may be disposed. In the present embodiment, a case in which the first space S1 is disposed on a left side of the opening 12 and the second space S2 is disposed on a right side of the opening 12 is exemplified.

In order to secure contaminated air suction performance of the exhaust device, a size of the fan 40 needs to be sufficiently large. As a size of the fan 40 increases, suction performance increases, but the fan 40 correspondingly occupies a significant region of the component arrangement space S. Meanwhile, since the cooking appliance is generally disposed above an oven or a dishwasher, structural limitations are imposed on expansion of the component arrangement space S in an up-down direction.

Therefore, the fan 40 and the filters 50 and 55 are preferably arranged side by side along a horizontal direction rather than being stacked in an up-down direction. Accordingly, air introduced through the opening 12 flows along the flow paths d1 and d2 extending in a horizontal direction.

In addition, the fan 40 and the filters 50 and 55 are preferably disposed to be accommodated only in one of the first space S1 and the second space S2.

If the fan 40 is disposed in the first space S1 while at least one of the first filter 50 and the second filter 55 is disposed in the second space S2, or if the fan 40 is disposed on a right side of the opening 12 while at least one of the first filter 50 and the second filter 55 is disposed on a left side of the opening 12, a bent portion inevitably occurs in the flow paths d1 and d2.

For example, if the fan 40 is disposed in the first space S1 and the first filter 50 and the second filter 55 are disposed in the second space S2, a bent section for direction change occurs between a section of the flow paths d1 and d2 extending rightward from the opening 12 toward the first filter 50 and a section extending leftward from the second filter 55 toward the fan 40. Such a bent section of the flow paths d1 and d2 becomes a cause of increased flow resistance.

In consideration of this, in the present embodiment, the fan 40 and the filters 50 and 55 are disposed to be accommodated only in one of the first space S1 and the second space S2. Accordingly, the flow paths d1 and d2 connecting the opening 12, the filters 50 and 55, and the fan 40 may be formed substantially straight without a bent section for direction change.

As the fan 40 and the filters 50 and 55 are disposed to be accommodated only in one of the first space S1 and the second space S2 in this manner, most of the corresponding space is occupied by the fan 40 and the filters 50 and 55. Accordingly, the electrical part 30 may be disposed in the other one of the first space S1 and the second space S2. For example, as the fan 40 and the filters 50 and 55 are disposed in the first space S1, the electrical part 30 is disposed in the second space S2, which is a space in which the fan 40 and the filters 50 and 55 are not disposed.

As the fan 40 and the filters 50 and 55 are disposed to be accommodated only in one of the first space S1 and the second space S2, a sufficient free space may be secured in the other one of the first space S1 and the second space S2, and the electrical part 30 may be disposed in the free space secured in this manner.

That is, by the arrangement structure of the fan 40 and the filters 50 and 55 as described above, not only arrangement efficiency of the fan 40 and the filters 50 and 55 may be secured, but also advantages favorable for reducing flow resistance and securing space required for arrangement of the electrical part 30 may be provided.

According to the present embodiment, the filters 50 and 55 may be disposed approximately at a center of the component arrangement space S in a left-right direction. For example, if the opening 12 is disposed at a left-right direction center of the component arrangement space S, the first filter 50 may be disposed directly below the opening 12, and the second filter 55 may be disposed at a position slightly offset leftward therefrom.

In a horizontal direction, the filters 50 and 55 may be disposed to block between the fan 40 and the fluid collection part 65, and between the fan 40 and the electrical part 30. The fan 40 may be disposed on a left side of the filters 50 and 55, and the electrical part 30 may be disposed on a right side of the filters 50 and 55. The fluid collection part 65 may also be disposed on a right side of the filters 50 and 55.

With respect to the vertical direction, at least a portion of the fluid collection part 65 may be disposed below the filters 50 and 55, more specifically below the first filter 50. As an example, the fluid collection part 65 may be arranged such that a bottom surface of a collection tray 653 in which a liquid fluid is collected is disposed at a position lower than a lower end of the first filter 50.

This is to allow a collection position of the liquid fluid to be at a position lower than the first filter 50. In this manner, as the fluid collection part 65 is disposed at a position lower than the first filter 50, the liquid fluid filtered by the first filter 50 may be effectively collected in the collection tray 653.

The fluid collection part 65 as described above may be disposed together with the electrical part 30 in the same space, for example, in the second space S2. In other words, the fluid collection part 65 may be disposed in a partitioned space in which the fan 40 is not disposed, that is, in a partitioned space other than the first space S1.

A size of the fluid collection part 65 is closely related to a collection capacity of the liquid fluid. If the collection capacity of the fluid collection part 65 is small, not only inconvenience of frequently emptying the liquid fluid may occur, but also a risk that the liquid fluid overflows and leaks from the fluid collection part 65 may increase.

In order to increase the size of the fluid collection part 65, it is necessary to increase a length in the vertical direction or a horizontal direction. However, increasing the length in the upward direction has no substantial effect, and since an installation position of the fluid collection part 65 is already considerably low, structural constraints accompany extending the length in the downward direction.

In consideration of these points, in order to increase the size of the fluid collection part 65, it is preferable to increase a length in the horizontal direction. However, considering that the fluid collection part 65 and the electrical part 30 share the same space, there is also a limitation in indefinitely increasing the length of the fluid collection part 65 in the horizontal direction.

In consideration of these structural constraints, the present embodiment proposes a configuration in which the fluid collection part 65 is disposed at a position lower than the electrical part 30. That is, with respect to the vertical direction, the fluid collection part 65 may be disposed below the electrical part 30 such that the electrical part 30 is disposed between the top plate 10 and the fluid collection part 65.

The fan 40 is a component that requires a sufficient length in the vertical direction to improve performance, whereas the electrical part 30 only needs to have a size sufficient to stably accommodate internal electrical components. In particular, in order to efficiently arrange the electrical components within the electrical part 30, a space in the horizontal direction is more important than a space in the vertical direction, and securing a sufficient length in the horizontal direction is more advantageous in terms of arrangement efficiency.

As described above, unlike the fan 40, the electrical part 30 does not need to be designed to be long in the vertical direction for performance improvement, and a vertical-direction length sufficient to stably accommodate the internal electrical components may be sufficient. Accordingly, a certain level of free space may be secured below the electrical part 30, and this space may serve as a potential installation region for more efficiently utilizing an internal space of the cooking appliance.

In particular, such free space below may be effectively utilized as an installation space for securing a size of the fluid collection part 65. For this purpose, the fluid collection part 65 is preferably disposed at a position lower than the electrical part 30, that is, to correspond to a position of the free space formed below the electrical part 30. Such an arrangement structure provides an advantage of sufficiently securing the collection capacity of the fluid collection part 65 while maximizing space efficiency within the cooking appliance.

### [Second flow path]

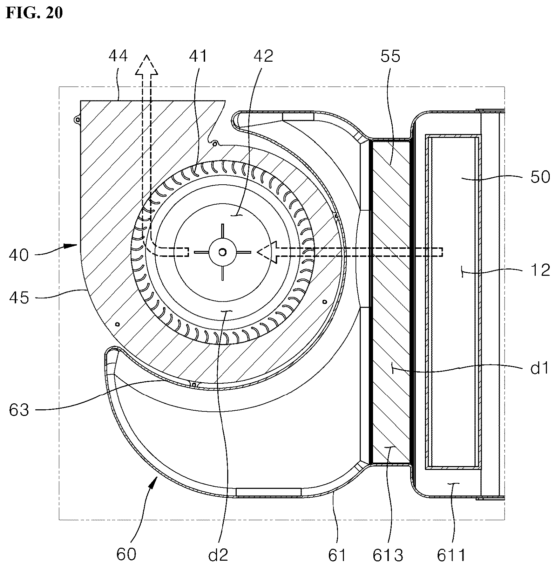

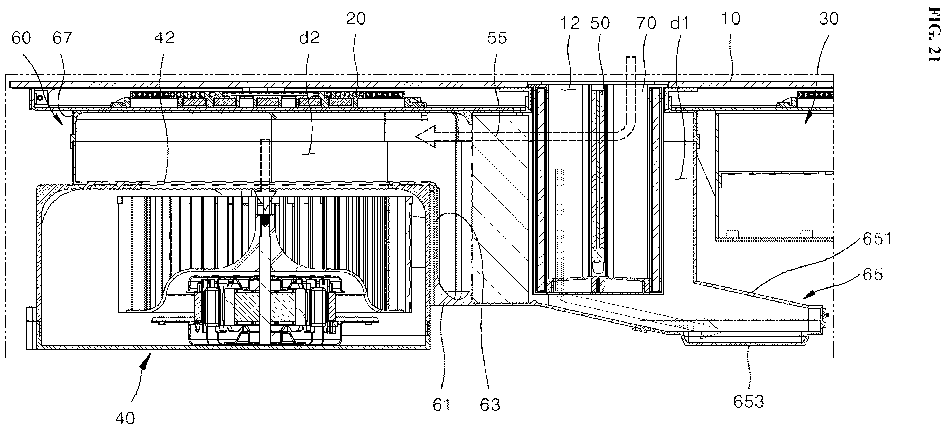

FIGS. 20 and 21 are cross-sectional views illustrating a fluid flow within the exhaust device, in which FIG. 20 is a plan cross-sectional view and FIG. 21 is a front cross-sectional view.

Referring to FIGS. 19 to 21, flow paths d1 and d2 for guiding a flow of air are formed in the interior of the hood housing 60, and the flow paths d1 and d2 may include a first flow path d1 and a second flow path d2. The first flow path d1 is formed as a path that guides contaminated air introduced through the opening 12 to sequentially pass through the first filter 50 and the second filter 55.

The second flow path d2 may be disposed in a space formed between the intake port 42 and the top plate 10, which are spaced apart from each other in the vertical direction. In the present embodiment, since the intake port 42 is positioned above the fan 40 and the top plate 10 is disposed at an uppermost portion of the cooking appliance, a space formed between the intake port 42 and the top plate 10 naturally constitutes the second flow path d2.

The second flow path d2 disposed as described above functions as a passage connecting the first flow path d1 and the intake port 42. Accordingly, air that has passed through the filters along the first flow path d1 may flow into an interior of the fan 40 through the intake port 42 via the second flow path d2.

That is, air introduced from outside the cooking appliance flows into the first flow path d1 through the opening 12, and passes through the first filter 50 and the second filter 55 while moving along the first flow path d1. The filtered air then flows along the second flow path d2 formed above the fan 40 and is introduced into the intake port 42, and is drawn into the interior of the fan 40 through the intake port 42. In this manner, the second flow path d2 may provide an independent flow path that guides only purified air that has passed through the filters to the fan.

According to the present embodiment, in order to improve suction performance of the fan 40, the fan 40 is arranged to be disposed at as low a position as possible within an allowable range. Accordingly, a vertical separation distance (up-down width) of a space between an upper side of the fan and the top plate 10, that is, the second flow path d2, is increased, and as a result, a cross-sectional area of the second flow path d2 may be expanded. Accordingly, an effective cross-sectional area required for the fan 40 to draw in air is increased, and as a result, suction performance of the fan 40 is effectively improved.

Meanwhile, as the fan 40 is disposed at a low position, a lower portion of the fan 40 is positioned in close contact with, or in extremely close proximity to, the fan base 47. Although the lower portion of the fan 40 is structurally open, due to such an arrangement structure, air inflow through the lower portion of the fan 40 is substantially blocked, and the fan 40 substantially draws in air only through the intake port 42 at the upper portion of the fan 40.

Such a structure has an advantageous aspect in concentrating an intake path of the fan 40 toward an upper side, but theoretically, there may be a concern that performance deteriorates due to a limitation of an intake region of the fan 40.

However, in the present embodiment, since an up-down width of the second flow path d2 is sufficiently secured according to the low placement of the fan, thereby widening an intake passage, overall suction performance of the fan may be rather improved. That is, a structural characteristic of limiting intake from a lower portion of the fan 40 is effectively compensated through a design of the second flow path d2, and as a result, a substantial performance improvement of the fan 40 may be expected.

Ultimately, as the fan 40 is disposed at a low position, a space between an upper side of the fan 40 and the top plate 10 is sufficiently secured, and an up-down width of the second flow path d2 formed in this space is widened. Such a structure effectively increases an effective cross-sectional area required for the fan 40 to draw in air, thereby contributing to stably improving suction performance of the fan 40.

In addition, such a configuration not only results in a simple performance improvement, but also provides a favorable design advantage in that efficiency of fluid flow and a degree of design freedom of an internal space of the cooking appliance are increased. By stably disposing the fan 40 at a lower portion and providing a smooth flow path at an upper portion, overall air intake efficiency and operational stability of the exhaust device may be secured at the same time.

### [Overall structure of electrical part]

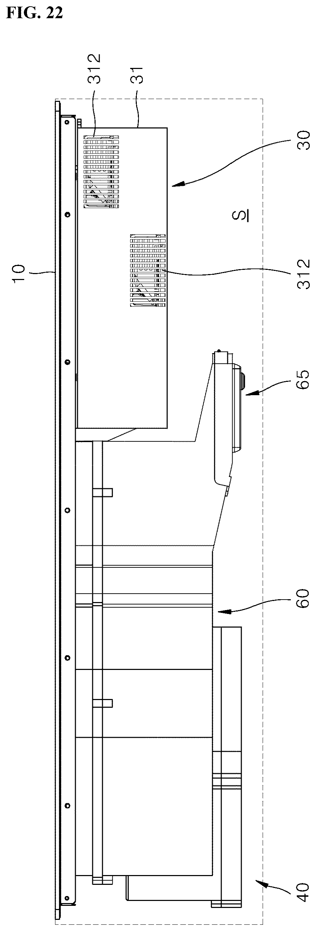

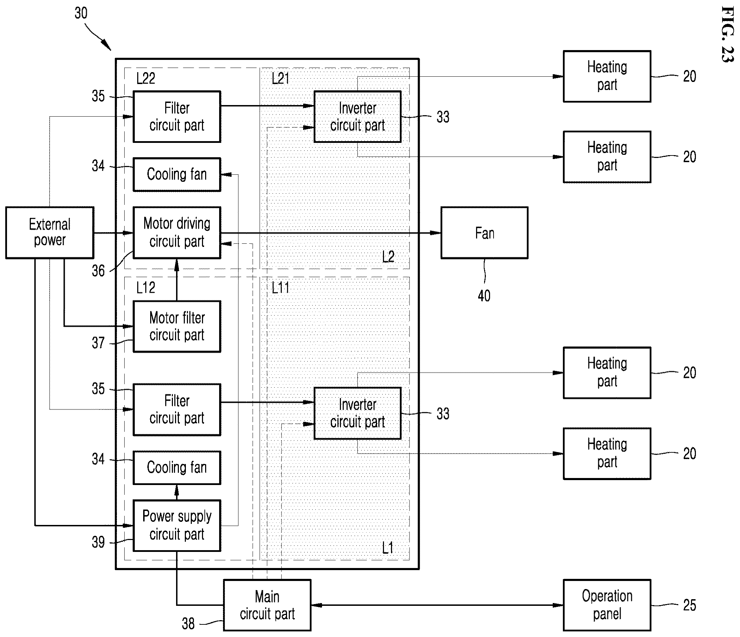

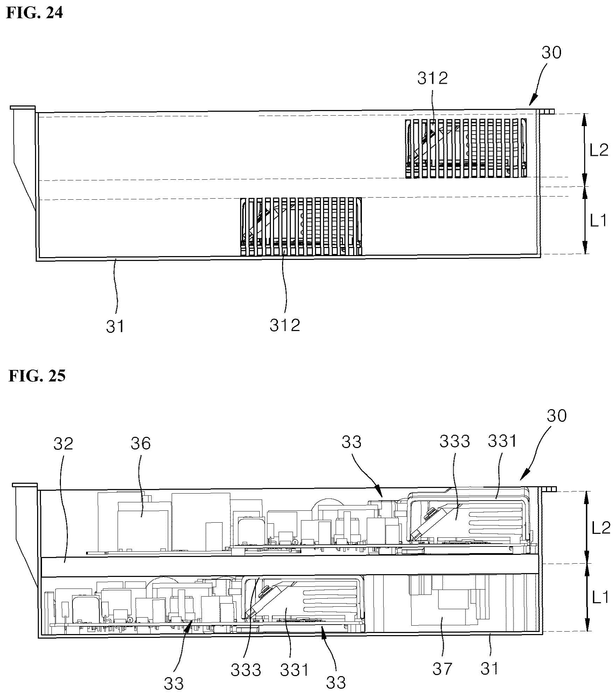

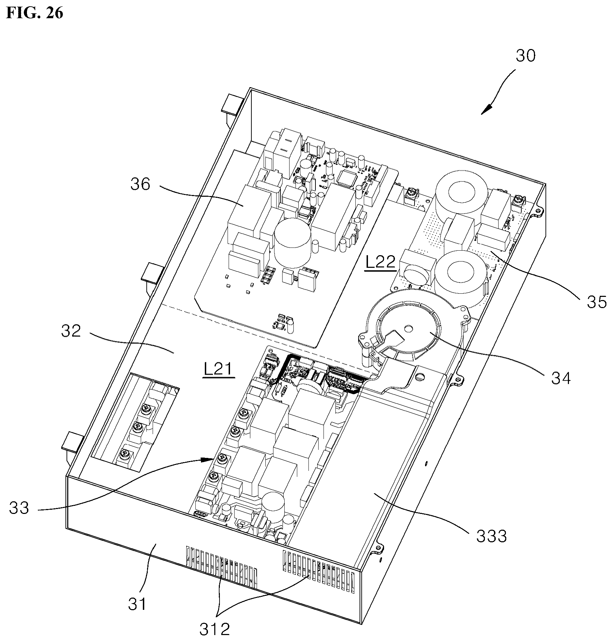

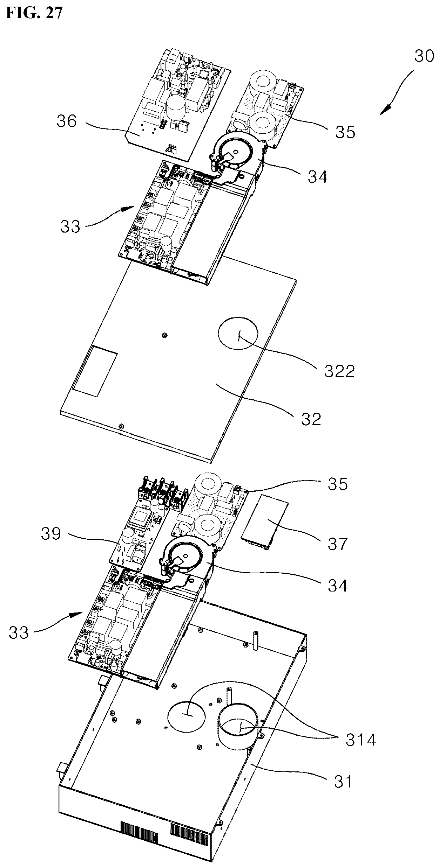

FIG. 22 is a front view showing a cooking appliance according to another embodiment of the present disclosure, FIG. 23 is a block diagram showing a configuration of the cooking appliance shown in FIG. 22, and FIG. 24 is a front view showing the electrical part shown in FIG. 22 in a disassembled state. Further, FIG. 25 is a front sectional view showing an internal structure of the electrical part shown in FIG. 24, FIG. 26 is a perspective view showing an internal structure of the electrical part shown in FIG. 24, and FIG. 27 is an exploded perspective view showing an exploded state of the electrical part shown in FIG. 26.

Referring to FIGS. 7 and 22, the electrical part 30 is disposed in a component arrangement space S provided below the top plate 10. The component arrangement space S is a space in which the fan 40, the filter 50, the fluid collection part 65, and the electrical part 30 are disposed together, and a horizontal shape and size thereof are substantially limited by a range covered by the top plate 10. Accordingly, arrangement of the electrical part 30 needs to be efficiently made within an available region of the component arrangement space S.

An upper boundary of the component arrangement space S may be defined by a lower surface of the top plate 10. A lower boundary is not limited by a separate structure, but may be substantially determined according to lower end positions of components such as the fan 40, the filter 50, the fluid collection part 65, and the electrical part 30.

Among these, the fan 40 is a component that requires a greatest height (thickness) in terms of performance, and serves as a reference element that determines an overall height of the component arrangement space S. Therefore, in order for the electrical part 30 to be disposed within the component arrangement space S, an up-down direction dimension of the electrical part 30 needs to be designed to not be greater than an up-down direction length of the fan 40.

According to the present embodiment, as illustrated in FIGS. 22 to 25, the electrical part 30 has an electrical case 31 including electrical component spaces L1 and L2 therein, and the electrical component spaces L1 and L2 may be partitioned in the up-down direction. Through this, an interior of the electrical part 30 forms a two-stage structure, and the functional circuit part 33 and related electrical components may be disposed in each stage.

Such a multi-stage structure contributes to enabling efficient arrangement of the electrical part 30 within a limited space of the component arrangement space S by allowing a plurality of electrical components to be effectively accommodated while minimizing a horizontal-direction dimension of the electrical part 30.

Referring to FIGS. 23 to 27, the electrical part 30 may include the functional circuit part 33. The functional circuit part 33 is disposed in the electrical component spaces L1 and L2, and may include an inverter circuit part 33 for controlling operation of the heating part 20 of the cooking appliance.

The inverter circuit part 33 converts alternating current power supplied from outside into direct current power, and then converts the direct current power again into alternating current power having a desired frequency and voltage and applies the alternating current power to the heating part 20, whereby a heat generation amount and control characteristics of the heating part 20 may be precisely adjusted. For convenience of description, hereinafter, the inverter circuit part 33 will be used with the same meaning as the functional circuit part 33.

The heating part 20 includes a working coil that generates an induced current in a cooking vessel disposed on a top plate to heat a heating target, and the working coil may be driven by power supplied from the inverter circuit part 33. The inverter circuit part 33 controls a voltage, a frequency, and the like applied to the working coil, whereby a cooking temperature and a heat generation intensity may be precisely adjusted.

In the present embodiment, two heating parts 20 are electrically connected to one functional circuit part 33, that is, one inverter circuit part 33, and each functional circuit part 33 is exemplified as independently performing control of a corresponding heating part 20.

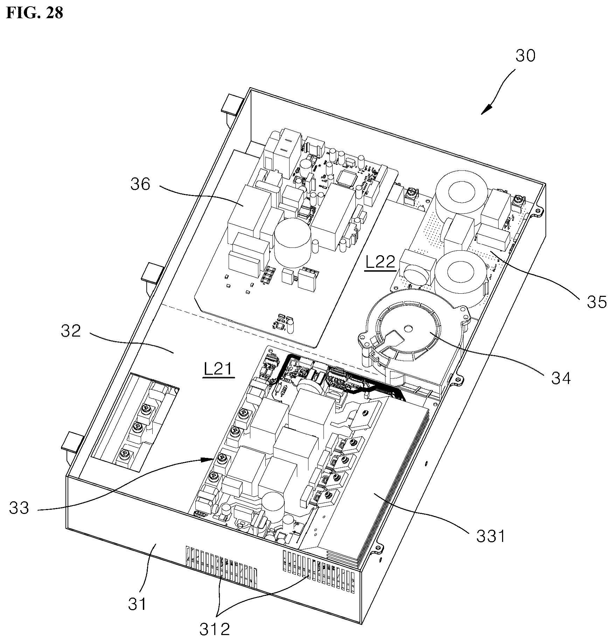

FIG. 27 is an exploded perspective view illustrating an exploded state of the electrical part shown in FIG. 26, and FIG. 28 is a cross-sectional perspective view illustrating an internal structure of the electrical part shown in FIG. 26.

Referring to FIG. 28, the inverter circuit part 33 includes a heat-generating member (e.g., an IGBT, a MOSFET, etc.) that performs high-speed switching, and the heat-generating member generates a considerable amount of heat during operation. Accordingly, the inverter circuit part 33 may further include a heat dissipation member 331, such as a heat sink or a radiation plate, which is in thermal contact with the heat-generating member and is configured to dissipate heat to outside. The heat dissipation member 331 may be formed as a protruding structure from the inverter circuit part 33, and the heat-generating member may be installed on the heat dissipation member 331.

In addition, the electrical part 30 may further include various other electrical components other than the functional circuit part 33, as illustrated in FIGS. 23 to 28. As an example, the electrical part 30 may further include a cooling fan 34 and a duct 333. The cooling fan 34 and the duct 333 may be provided to control high heat generated in the inverter circuit part 33.

The duct 333 is provided to accommodate the heat dissipation member 331 therein. For example, the duct 333 may be formed in a cover shape above or below a circuit board on which the inverter circuit part 33 is mounted, and a flow path may be formed inside the duct 333. The heat-generating member and the heat dissipation member 331 in thermal contact therewith may be disposed in the flow path inside the duct 333.

The cooling fan 34 may be installed at one inlet of the duct 333, and may draw in outside air and supply the outside air into the interior of the duct 333. Air introduced into the interior of the duct 333 may cool the heat dissipation member 331 and the heat-generating member while passing therethrough, and may be guided to a discharge port 312 formed in the electrical case 31 through another outlet of the duct 333 and discharged to outside of the electrical part 30.

Inflow holes 314 and 322 may be formed in the electrical case 31 and the partition member 32, respectively. These may form passages for allowing the cooling fan 34 to draw in outside air and introduce the outside air into the interior of the electrical component space. Through the inflow holes 314 and 322, outside air is introduced from a lower portion of the electrical case 31 and is blown by the cooling fan 34, whereby cooling of the functional circuit part 33 and other heat-generating components disposed in the electrical component spaces L1 and L2 may be effectively achieved.

In addition, the electrical part 30 may further include a filter circuit part 35. The filter circuit part 35 may be provided to suppress generation of electromagnetic noise in the inverter circuit part 33.

According to the present embodiment, the functional circuit part 33, the cooling fan 34, and the filter circuit part 35 may be disposed together in each of the electrical component spaces L1 and L2. This is to efficiently dissipate heat generated by operation of the corresponding functional circuit part 33 and to suppress electromagnetic noise (EMI) and the like.

In this manner, as the functional circuit part 33, the cooling fan 34, and the filter circuit part 35 are disposed together in the same space and functionally interoperate with each other, operational stability of the circuit and thermal management efficiency may be simultaneously improved.

In addition, the electrical part 30 may further include a motor driving circuit part 36 for driving the fan 40, a corresponding motor filter circuit part 37, a main circuit part 38 for controlling overall operation of the cooking appliance, and a power supply circuit part 39 for power supply.

The power supply circuit part 39 receives external AC power and converts the external AC power into DC power, and then serves to stably supply power to various circuits such as the main circuit part 38, the functional circuit part 33, and the cooling fan 34. At this time, the power supply circuit part 39 is generally implemented in a form of a switched mode power supply (SMPS), and distributes power to control and auxiliary circuits required for overall operation of the cooking appliance.

The main circuit part 38 is a central control circuit that controls an overall system of the cooking appliance, and may generate commands for controlling operation of the functional circuit part 33. The main circuit part 38 may process and control various signals required for cooking operation, such as a user operation input, temperature sensing, an operation timer, and heating intensity control, and may receive power from the power supply circuit part 39.

These electrical components are distributed and disposed in the electrical component spaces L1 and L2 in consideration of space efficiency and thermal stability. In particular, the motor driving circuit part 36, which has a relatively large size compared to the main circuit part 38 and the motor filter circuit part 37, may be disposed alone in either the first electrical component space L1 or the second electrical component space L2, and the remaining main circuit part 38 and motor filter circuit part 37 may be disposed together in the other electrical component space.

In this manner, by dividing an interior of the electrical part 30 into two stages and vertically stacking the functional circuit part 33 and auxiliary circuits in each stage, a high-functionality electrical circuit configuration may be realized without increasing an overall horizontal width of the cooking appliance.

Meanwhile, the cooking appliance may further include an operation panel 25. The operation panel 25 is provided to allow a user to set various cooking conditions or check a cooking operation state.

The operation panel 25 is electrically connected to the main circuit part 38 of the electrical part 30 and may transmit various input signals to the main circuit part 38. As an example, the operation panel 25 may be disposed at a front portion of the top plate 10, and may be disposed on a lower surface of the top plate 10. For example, the operation panel 25 may be installed on the lower surface of the top plate 10.

### [Arrangement structure of electrical components of electrical part]

According to the electrical part 30 of the present embodiment, electrical component spaces L1 and L2 inside the electrical case 31 are divided into a first electrical component space L1 and a second electrical component space L2, and various electrical components may be distributed and disposed in each space according to function. Accordingly, space efficiency of the electrical part 30 as a whole and stability of circuit configuration may be improved.

Each layer within the electrical component spaces L1 and L2 may be further divided into a first space portion L11 and L21 in which the functional circuit part 33 is disposed, and a second space portion L12 and L22 in which electrical components other than the functional circuit part 33 are disposed. Accordingly, within each of the electrical component spaces L1 and L2, the inverter circuit part 33 serving as a main heat source and auxiliary components thereof (the cooling fan, the filter circuit part, and the like) may be configured to be structurally separated while being functionally closely interlinked.

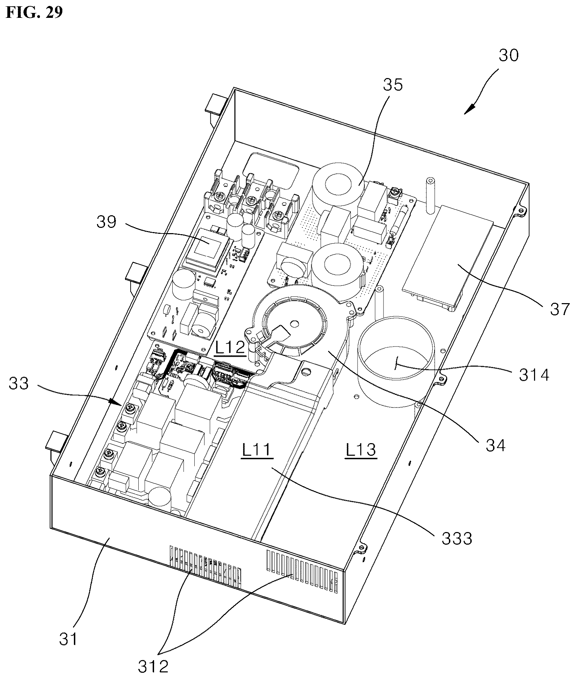

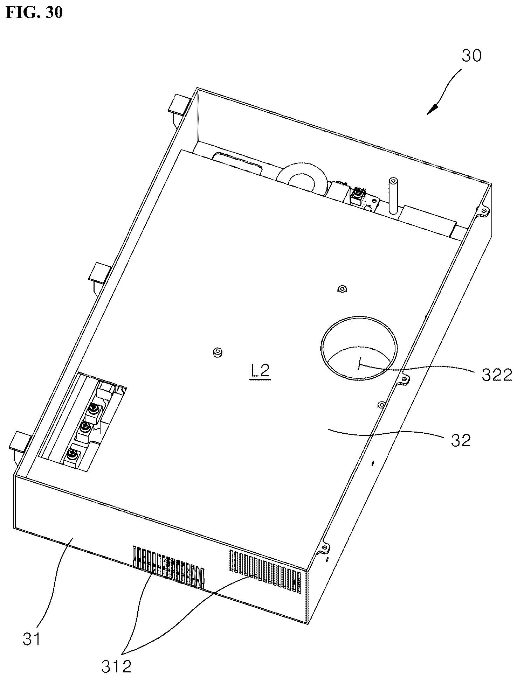

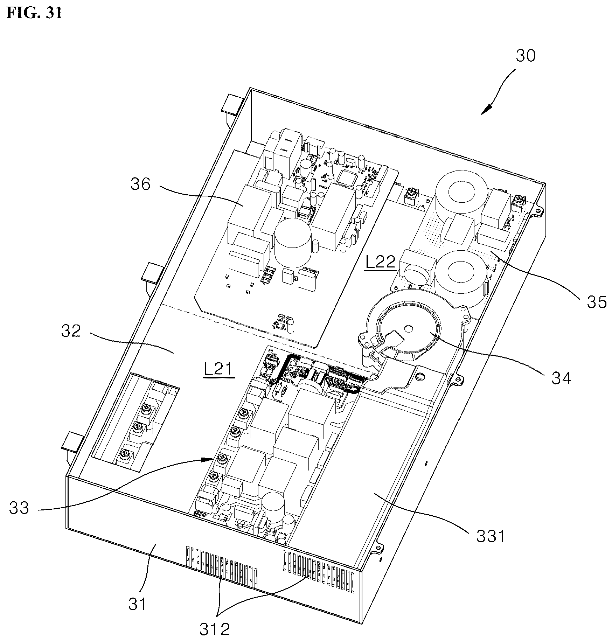

FIG. 29 is a view showing a first-floor stacked state of the electrical part, and FIGS. 30 and 31 are views showing a second-floor stacking process of the electrical part.

Referring to FIG. 29, the inverter circuit part 33 is disposed in the first space portion L11 of the first electrical component space L1, and the filter circuit part 35, the main circuit part 38, the motor filter circuit part 37, and the like may be disposed together in the second space portion L12. Accordingly, the filter circuit part 35, the main circuit part 38, and the motor filter circuit part 37 may be disposed to be spaced apart from the inverter circuit part 33 in a horizontal direction, for example, in a front-rear direction. This is a result of a structural arrangement for preventing heat generated by the inverter circuit part 33 from thermally affecting other electrical components.

Referring to FIG. 30, a partition member 32 may be installed inside the electrical case 31. The partition member 32 forms a horizontal surface extending across the electrical component spaces L1 and L2 in a horizontal direction, and may divide the electrical component spaces L1 and L2 into upper and lower portions.

The partition member 32 is fixed to an inner wall of the electrical case 31, and may partition the first electrical component space L1 and the second electrical component space L2. In addition, the partition member 32 may be formed in a flat plate shape to serve as a support surface for vertical stacking of electrical components, and may provide a function of blocking thermal interference and electrical interference within the electrical component spaces L1 and L2.

Referring to FIG. 31, the second electrical component space L2 may be formed above the partition member 32. The functional circuit part 33 may be disposed in the first space portion L21 of the second electrical component space L2, and the motor driving circuit part 36 may be disposed in the second space portion L22. Accordingly, the inverter circuit part 33 and the motor driving circuit part 36 are disposed to be spaced apart from each other in a horizontal direction, for example, in a front-rear direction, and this is a structural arrangement for preventing heat generated by the inverter circuit part 33 from thermally affecting other electrical components.

In the second electrical component space L2, the motor driving circuit part 36, which has a relatively large size compared to electrical components disposed in the second space portion L12 of the first electrical component space L1, may be disposed alone.

The motor driving circuit part 36 is a power circuit that controls high current, and has a larger amount of heat generation and a relatively higher possibility of electromagnetic interference compared to the filter circuit part 35, the main circuit part 38, and the motor filter circuit part 37. Therefore, such a motor driving circuit part 36 is preferably disposed separately from small-sized low-heat-generating circuits.

Accordingly, the motor driving circuit part 36 may be disposed alone in the second space portion L22 of the second electrical component space L2 among the electrical component spaces that are partitioned in the up-down direction by the partition member 32 within the electrical part 30.

In addition, the first electrical component space L1 and the second electrical component space L2 are separated from each other in the up-down direction by the partition member 32, and the partition member 32 may be fixed to an inner wall of the electrical case 31 or installed through a latching structure.

The partition member 32 forms a physical boundary between the first electrical component space L1 and the second electrical component space L2, thereby not only stably supporting electrical components installed in the second electrical component space L2, but also effectively blocking thermal interference and electromagnetic interference between the electrical component spaces L1 and L2.

Referring to FIGS. 27 to 31, an interior of the electrical part 30 includes the first electrical component space L1 and the second electrical component space L2 that are partitioned in the up-down direction, and each of the electrical component spaces L1 and L2 may be further divided into a first space portion L11 and L21 in which the functional circuit part 33 is disposed, and a second space portion L12 and L22 in which other electrical components are disposed.

The functional circuit part 33 is disposed in the first space portion L11 of the first electrical component space L1, and the filter circuit part 35, the main circuit part 38, the motor filter circuit part 37, and the like may be disposed together in the second space portion L12. At this time, electrical components disposed in the second space portion L12 are formed to be spaced apart from the functional circuit part 33 in a horizontal direction, for example, in a front-rear direction, in order to reduce thermal interference, and may be implemented in a structure that is planarly arranged within the electrical case 31.

In addition, the functional circuit part 33 is disposed in the first space portion L21 of the second electrical component space L2, and the motor driving circuit part 36 having a large size may be disposed alone in the second space portion L22. As the motor driving circuit part 36 is arranged in this manner, heat dissipation of the motor driving circuit part 36 having a large amount of heat generation may be facilitated, and thermal interference with a lower space may be prevented.

In addition, as another example, a modified embodiment is also possible in which the motor driving circuit part 36 is disposed in the first electrical component space L1, and other electrical components such as the main circuit part 38 and the motor filter circuit part 37 are disposed in the second electrical component space L2. Such modifications may be appropriately adjusted according to a designer's selection in consideration of a wiring configuration within the electrical part, a heat dissipation path, and an interference distance between circuits.

As described above, the electrical part 30 of the present embodiment may disperse and dispose the functional circuit part 33 and auxiliary circuits thereof in an up-down direction and in a planar direction through the partitioned electrical component spaces L1 and L2 according to functional characteristics, amounts of heat generation, and interference sensitivities, whereby interference between high-heat-generating and high-frequency circuits and low-power control circuits may be effectively blocked, and stability of an overall circuit arrangement and cooling efficiency may be simultaneously ensured.

Meanwhile, a third space portion L13 may be formed in the electrical part 30. By way of example, the first space portion L11 and the second space portion L12 may be arranged in a front-rear direction, and the third space portion L13 may be formed on one side in a lateral direction of the first space portion L11 and the second space portion L12. The third space portion L13 may be left empty or, in some cases, may be provided with a wire guiding space, a reinforcement structure, or a fixing member.

Above the third space portion L13, the inverter circuit part 33 disposed in the second electrical component space L2 is located. That is, the third space portion L13 may form a space below the inverter circuit part 33 disposed in the second electrical component space L2.

According to the present embodiment, the electrical case 31 may be formed in a hexahedral shape, more specifically, a rectangular parallelepiped shape, and accordingly, an overall shape of the electrical component spaces L1 and L2 may also be formed in a rectangular parallelepiped shape.

In addition, at least a portion of the functional circuit part 33 disposed in the first electrical component space L1 and the functional circuit part 33 disposed in the second electrical component space L2 may be disposed at positions offset from each other in a horizontal direction. In the present embodiment, the functional circuit part 33 disposed in the first electrical component space L1 and the functional circuit part 33 disposed in the second electrical component space L2 are exemplified as being disposed at positions offset from each other in a lateral direction.

In addition, the functional circuit part 33 may include a first region and a second region. The first region is defined as a region in which a heat dissipation member 331 on which heat-generating components are installed is disposed. The second region is defined as a region in which the heat dissipation member 331 is not disposed.

In the present embodiment, the first region and the second region may be arranged in a horizontal direction, and the second region of the functional circuit part 33 disposed in the first electrical component space L1 and the second region of the functional circuit part 33 disposed in the second electrical component space L2 are exemplified as being disposed at positions offset from each other in the horizontal direction. That is, the second regions of the functional circuit parts 33 disposed in upper and lower layers are disposed at positions offset from each other in a lateral direction. Accordingly, up-down directional overlap between identical regions of the functional circuit parts 33 may be avoided, and thermal interference and electromagnetic interference between the functional circuit parts 33 may be suppressed.

The third space portion L13 is a spare space naturally formed as a structural result of the rectangular parallelepiped shape of the electrical case 31 and the up-down directional arrangement and lateral offset arrangement of the functional circuit parts 33 being applied together.

The third space portion L13 is positioned between the functional circuit parts 33 disposed in the first electrical component space L1 and the second electrical component space L2, thereby providing a space in which heat may be diffused around the functional circuit parts 33. In particular, the third space portion L13 is positioned below the inverter circuit part 33 disposed in the second electrical component space L2, thereby providing an environment in which heat generated from the corresponding circuit part may be smoothly diffused downward, whereby cooling efficiency and thermal stability may be improved.

In addition, the cooling fan 34 is disposed adjacent to a region in which the functional circuit part 33 and the heat dissipation member 331 are disposed. Accordingly, cooling air supplied by the cooling fan 34 may be efficiently introduced into the duct 333, and heat of heat-generating components may be rapidly removed. As a result, stability and durability of the inverter circuit part 33 as a whole may be improved.

The main circuit part 38 is a central control circuit that comprehensively controls operation of the entire electrical part, receives power from the power supply circuit part 39, and may comprehensively determine states of the functional circuit parts 33, user inputs, and sensor information to control overall operation of the cooking appliance. Such a main circuit part 38, together with the filter circuit part 35 and the motor filter circuit part 37, may be selectively disposed in the first electrical component space L1 or the second electrical component space L2.

Overall, an upper-lower two-stage structure of the electrical part 30 contributes to implementing an optimized circuit arrangement by comprehensively considering functional roles, heat generation characteristics, electromagnetic interference, and wiring connection structures among the electrical components.

In particular, circuit accommodation capacity may be doubled within the same horizontal width, and by minimizing interference between components, circuit reliability, control precision, and maintainability may all be improved.

In addition, a multi-stage structure in which the electrical component spaces L1 and L2 are partitioned in an up-down direction enables various electrical components having different functions to be efficiently accommodated without increasing a horizontal size of the electrical part 30, and allows a high-function electrical configuration to be implemented even within a limited space below the top plate 10.

### [Second Example of Electrical part]

Meanwhile, the electrical part having the above-described structure is merely one embodiment of the present disclosure, and various modifications of the electrical part may be possible.

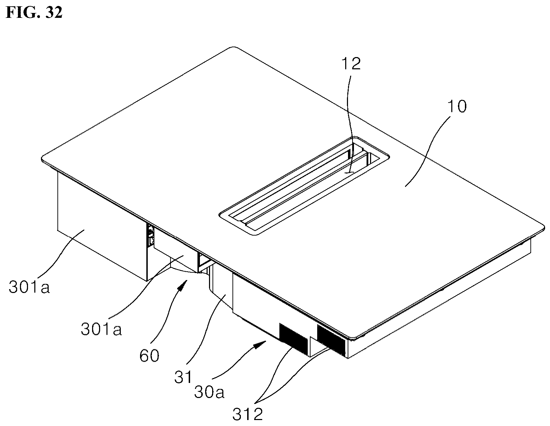

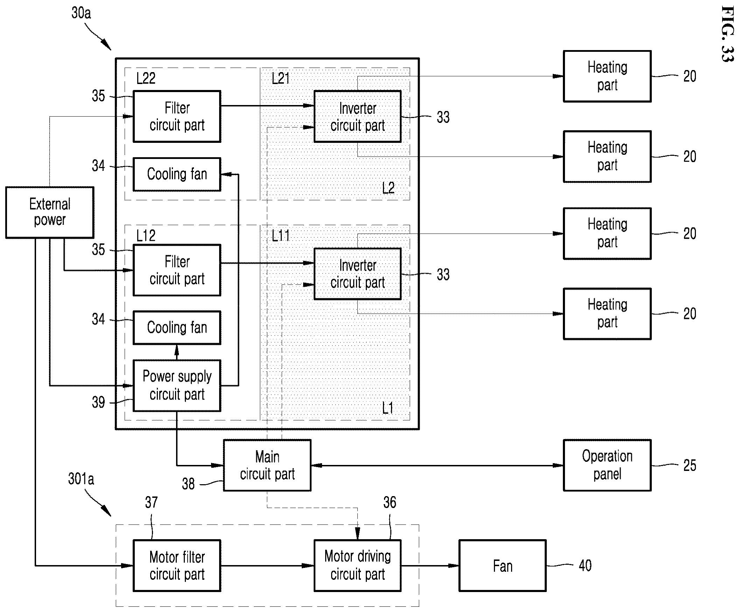

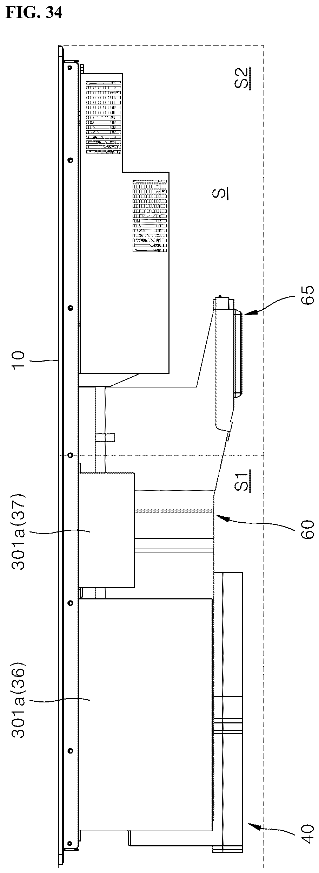

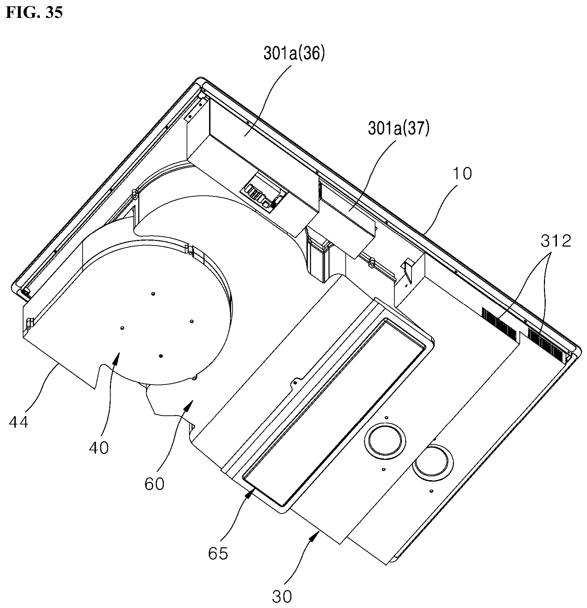

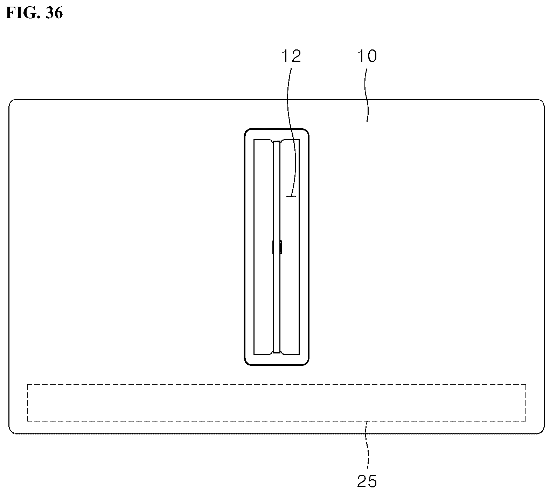

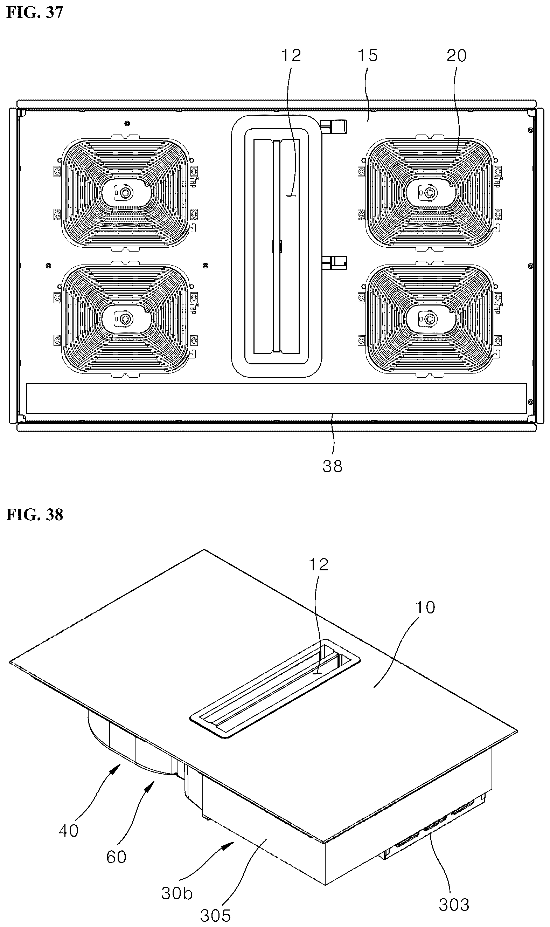

FIG. 32 is a perspective view showing a cooking appliance according to another embodiment of the present disclosure, FIG. 33 is a block diagram showing a configuration of the cooking appliance shown in FIG. 32, and FIG. 34 is a front view of the cooking appliance shown in FIG. 32. FIG. 35 is a bottom perspective view of the cooking appliance shown in FIG. 32, FIG. 36 is a plan view of the cooking appliance shown in FIG. 32, and FIG. 37 is a plan view showing a state in which the top plate is removed from the cooking appliance shown in FIG. 35.

Hereinafter, with reference to FIGS. 32 to 37, modified examples of the electrical part will be described.

The cooking appliance according to the present embodiment may include a main electrical part 30a and a sub electrical part 301a. These electrical parts are disposed at positions spaced apart from each other within a component arrangement space S provided below the top plate 10 of the cooking appliance, and may respectively and distributively accommodate various electrical components for operation of the cooking appliance.

The main electrical part 30a includes a functional circuit part such as an inverter circuit part 33, and may be disposed in a partitioned space on a side on which the fan 40 is not disposed. For example, the main electrical part 30a may be disposed in the second space S2.

On the other hand, at least a portion of the sub electrical part 301a may be disposed in a partitioned space in which the main electrical part 30a is not disposed. That is, at least a portion of the sub electrical part 301a may be disposed in a partitioned space in which the fan 40 is disposed, and for example, may be disposed in the first space S1.

As described above, the main electrical part 30a is disposed in the second space S2 at a rear side on which the fan 40 is not disposed, and the sub electrical part 301a is disposed in the first space S1 in which the fan 40 is disposed, whereby the electrical parts may be stably installed at positions spaced apart from each other without mutual interference.

The sub electrical part 301a may include electrical components related to driving of the fan 40, such as a motor driving circuit part 36 and a motor filter circuit part 37, and may be disposed at a position adjacent to the fan 40. In consideration that an exhaust port 44 of the fan 40 is formed at a rear side of the fan, the sub electrical part 301a may be disposed at a front side of the fan 40 so as not to interfere with an exhaust flow.

Such an arrangement provides an advantage in that, by shortening an electrical connection path between the fan 40 and the sub electrical part 301a, efficiency of a wiring configuration may be increased, and electrical interference or loss and delay of control signals may be minimized.

In addition, the sub electrical part 301a may be disposed using a space located at a front side relative to the heating part 20 so as not to overlap the heating part 20 in an up-down direction.

By such a structure, the sub electrical part 301a may be stably installed within a space formed at a front side of the fan 40, and by being physically spaced apart from a high-temperature environment generated around the heating part 20, interference of heat or thermal stress may be minimized.

Meanwhile, an operation panel 25 may be disposed in a front region of the cooking appliance, and correspondingly, the main circuit part 38 may also be disposed in the front region of the cooking appliance. The main circuit part 38 may be disposed below the operation panel 25 and may be electrically connected to the operation panel 25.

For example, the operation panel 25 may be disposed in a front-side region of the top plate 10 and may be installed on a lower surface of the top plate 10, and the main circuit part 38 may be accommodated in the heating part case 15 and may be disposed in a front-side region of the heating part case 15.

According to the present embodiment, the sub electrical part 301a may be disposed below the main circuit part 38. For example, the sub electrical part 301a may be disposed below the heating part case 15.

In this case, as the sub electrical part 301a is positioned at a front side of the fan 40, a distance to the main circuit part 38 may also be reduced, and wiring paths for control signals and power supply may be simplified. In addition, the main circuit part 38 may be disposed below the operation panel 25 to receive operation signals. Such an upper-lower arrangement relationship between the main circuit part 38 and the sub electrical part 301a allows connections between circuits to be configured more simply and stably.

The motor driving circuit part 36 and the motor filter circuit part 37 included in the sub electrical part 301a may be arranged side by side in a horizontal direction and may each be accommodated in separate electrical cases. For example, they may be disposed in parallel within a front-side space of the fan 40 and the hood housing 60.

As described above, by providing the two circuit parts of the sub electrical part 301a in a separated structure, electromagnetic interference between circuits may be reduced, and cooling paths according to heat generation characteristics may also be separated, whereby efficient thermal management may be achieved. Accordingly, circuit components included in the sub electrical part 301a may be operable under more stable temperature conditions, and long-term durability and reliability of the circuits may also be improved.

As described above, as the motor driving circuit part 36 and the motor filter circuit part 37 are provided as separate configurations, electromagnetic interference between circuits may be reduced, and cooling paths according to heat generation characteristics of the respective electrical components may be separated, whereby efficient thermal management may be achieved.

Furthermore, as the two circuit parts, that is, the motor driving circuit part 36 and the motor filter circuit part 37, are provided in separate structures, an advantage is also provided in that respective installation positions may be flexibly selected. If the two circuit parts are configured integrally, an integrated space suitable for an overall size and shape is required, whereby arrangement constraints may be increased.

On the other hand, when the motor driving circuit part 36 and the motor filter circuit part 37 are provided as separate components as in the present embodiment, individual arrangement thereof becomes possible even in relatively narrow spaces, whereby space utilization of the cooking appliance and design freedom may be greatly improved.

In addition, circuit systems of the main electrical part 30a and the sub electrical part 301a may be configured independently from each other. That is, electrical components included in the sub electrical part 301a may be configured as an independent circuit system in which electrical control and power supply paths are separated from the functional circuit part 33 of the main electrical part 30a. Accordingly, circuit interference between the main electrical part and the sub electrical part may be prevented, and even if a failure occurs in a specific circuit system, an influence on an overall system may be minimized.

Furthermore, as some electrical components constituting the electrical part are separated into the sub electrical part 301a, a size of an electrical case of the main electrical part 30a may be reduced. Accordingly, even when it is difficult to accommodate all electrical components within the main electrical part 30a, electrical components essential for driving of the cooking appliance may be effectively and distributively installed using the sub electrical part 301a. As a result, design flexibility and component accommodation capability of the overall cooking appliance may be improved together.

### [Third Example of Electrical part]

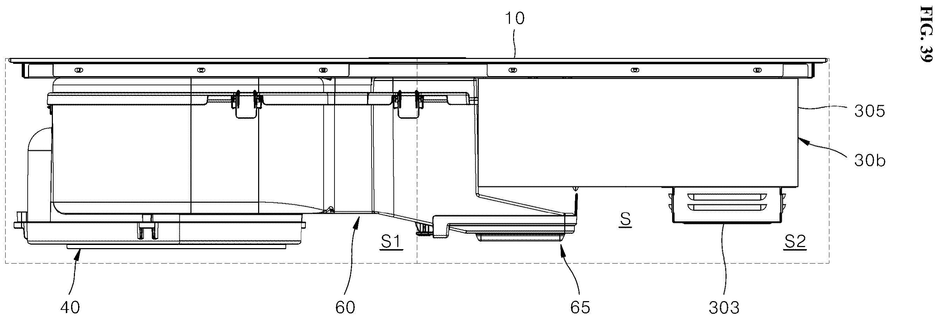

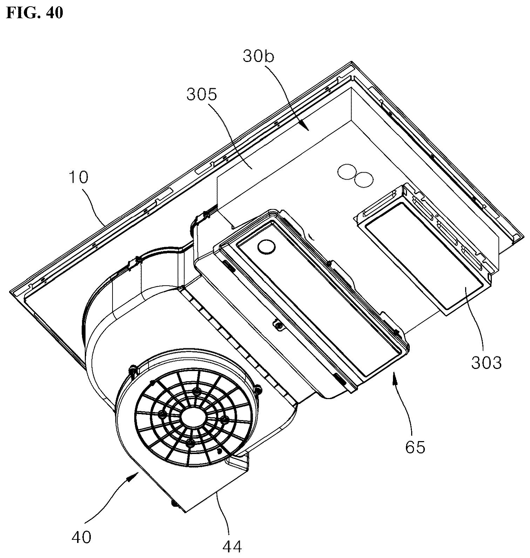

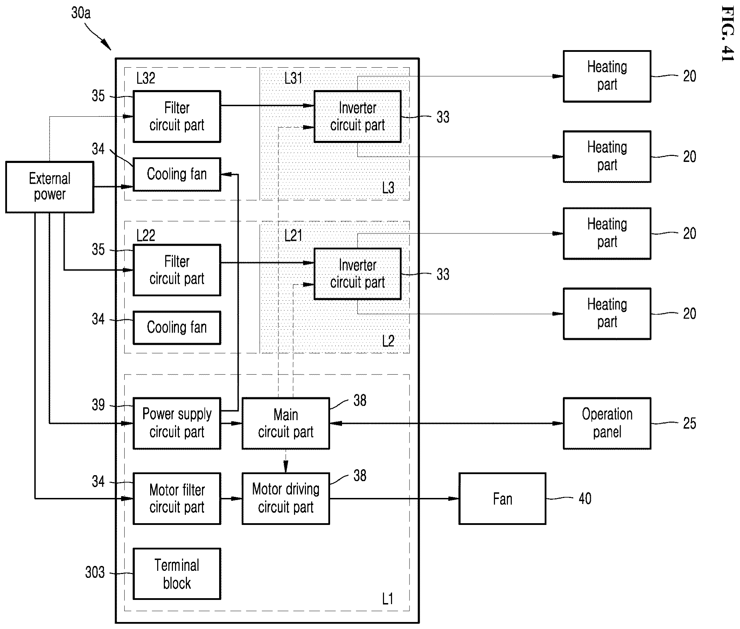

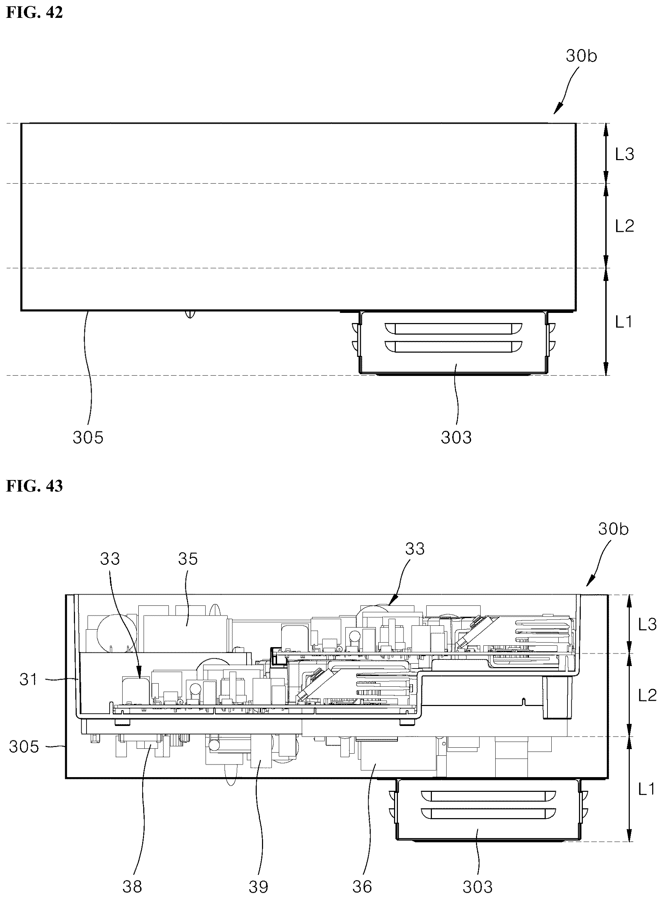

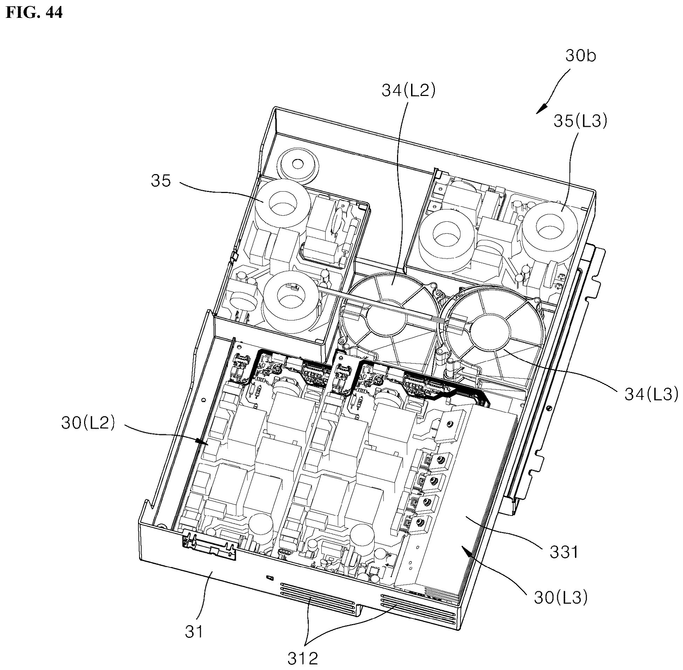

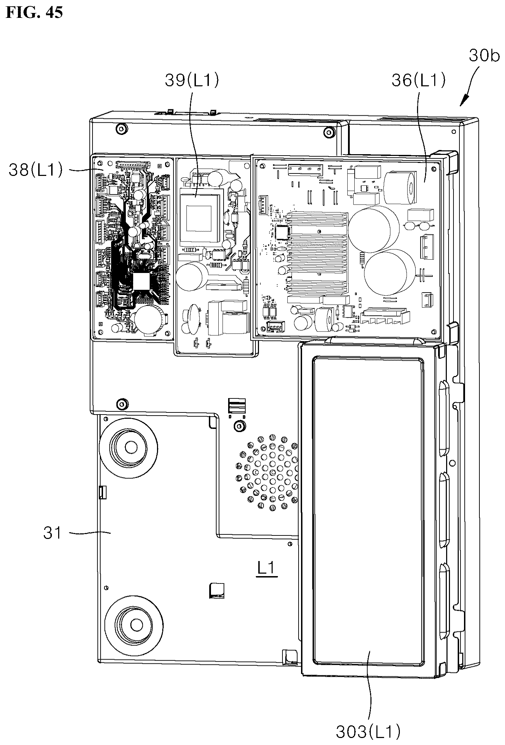

FIG. 38 is a perspective view showing a cooking appliance according to still another embodiment of the present disclosure, FIG. 39 is a front view of the cooking appliance shown in FIG. 38, and FIG. 40 is a bottom perspective view of the cooking appliance shown in FIG. 38. FIG. 41 is a block diagram showing a configuration of the cooking appliance shown in FIG. 38, and FIG. 42 is a front view showing the electrical part shown in FIG. 38 in a disassembled state. FIG. 43 is a front sectional view showing an internal structure of the electrical part shown in FIG. 42, FIG. 44 is a perspective view showing an internal structure of the electrical part shown in FIG. 42, and FIG. 45 is a bottom perspective view showing an internal structure of the electrical part shown in FIG. 42.

Referring to FIGS. 38 to 42, the electrical part 30b according to the present embodiment may form a three-layer structure including an electrical case 31 having therein a first electrical component space L2 and a second electrical component space L3 arranged in an up-down direction, and a lower electrical part L1 disposed outside and below the electrical case 31. By such a multi-layer structure, despite a limited space within the electrical case 31, distributive arrangement of various electrical components in the electrical part 30b according to functions may be enabled.

The first electrical component space L2 and the second electrical component space L3 are accommodation spaces formed as a result of an internal space of the electrical case 31 being partitioned in an up-down direction. The first electrical component space L2 is disposed at a lower portion, and the second electrical component space L3 is disposed at an upper portion, and as illustrated in FIGS. 41 to 45, a functional circuit part 33 may be disposed in each electrical component space.

The first space portion L21 of the first electrical component space L2 and the first space portion of the second electrical component space L3 may each have a functional circuit part 33 disposed therein, and these functional circuit parts 33 may be configured as inverter circuit parts including heat-generating members.

The functional circuit parts 33 disposed in the first electrical component space L2 and the second electrical component space L3 may be disposed to be offset from each other in a horizontal direction. Accordingly, the functional circuit part 33 of the first electrical component space L2 is not directly overlapped below the functional circuit part 33 installed in the second electrical component space L3, whereby thermal interference may be effectively prevented. In addition, the heat dissipation members 331 on which heat-generating components are installed are also disposed at positions offset from each other, thereby reducing heat accumulation in an up-down direction and improving cooling performance.

Each functional circuit part 33, that is, each inverter circuit part 33, may be divided into a first region in which the heat dissipation member 331 is disposed and a second region in which the heat dissipation member 331 is not disposed. In the present embodiment, the second region of the inverter circuit part 33 disposed in the first electrical component space L2 and the second region of the inverter circuit part 33 disposed in the second electrical component space L3 are exemplified as being disposed to be offset from each other in a lateral direction. Such an arrangement structure may provide an effect of suppressing thermal interference among electrical components while maximizing space utilization.

In the second space portion of the first electrical component space L2 and the second space portion of the second electrical component space L3, auxiliary electrical components other than the functional circuit part 33 are disposed. For example, in the second space portions of the first electrical component space L2 and the second electrical component space L3, a filter circuit part 35, a cooling fan 34, and the like may be disposed, and in the second space portions, a relatively large circuit component may be disposed alone or a plurality of low-heat-generating circuit parts may be densely disposed.

In the present embodiment, the filter circuit part 35 and the cooling fan 34 are exemplified as being disposed in the second space portions. By way of example, the filter circuit part 35 may be disposed in each of the first electrical component space L2 and the second electrical component space L3.

As another example, in the second space portion of the second electrical component space L3, a plurality of filter circuit parts 35 interworking with the functional circuit part 33 may be disposed together. For example, a filter circuit part 35 interworking with the functional circuit part 33 disposed in the first electrical component space L2 may also be disposed in the second electrical component space L3, whereby a structure in which a plurality of filter circuit parts 35 are disposed on the same layer may be formed.

As described above, when a plurality of filter circuit parts 35 are concentrically disposed on one layer, arrangement and fixing structures among the filter circuit parts 35 may be simplified. In addition, the above-described arrangement structure of the filter circuit parts 35 facilitates application of common structural components (e.g., fixing brackets, cable support portions), whereby a reduction in a number of parts and an improvement in assembly work efficiency may be achieved.

In addition, as a plurality of filter circuit parts 35 are disposed on the same layer, wiring work for the filter circuit parts 35 may be collectively performed, whereby a wiring process may be simplified and working time may be reduced, thereby enabling practical improvement in productivity.

Meanwhile, the lower electrical part L1 is disposed outside and below the electrical case 31, and may include electrical components of a different type from the functional circuit part 33. For example, a motor driving circuit part 36 for driving of the fan 40, the main circuit part 38, and a power supply circuit part 39 supplying power to the main circuit part 38 may be disposed in the lower electrical part L1.

As main circuit part 38, power supply circuit part 39, terminal blocks, and other circuit parts having high-current or high-heat-generation characteristics are concentrically disposed in the lower electrical part L1, only configurations centered on functional circuit parts such as the inverter circuit part 33 are disposed within an internal space of the electrical case 31.

Such an electrical component arrangement structure may effectively reduce arrangement interference between circuits through physical separation between high-frequency and high-heat-generation circuits and control circuits. In addition, the above-described electrical component arrangement structure may provide favorable conditions for heat dispersion and stable temperature maintenance of an overall circuit system by suppressing heat accumulation due to concentration of high-heat-generation components.

In particular, as high-heat-generation circuit parts are disposed outside the electrical case 31, cooling air flow inside the electrical case 31 may be facilitated, and heat dissipation efficiency may also be improved through interworking with cooling devices such as the cooling fan 34. As a result, an effect of comprehensively improving heat-handling performance and circuit stability of the overall system may be expected.

Electrical components included in the lower electrical part L1 may be installed on a bottom surface of the electrical case 31. That is, not only is the lower electrical part L1 disposed outside and below the electrical case 31, but components thereof are directly coupled to a bottom surface of the electrical case 31, whereby simplification of an assembly structure and stable fixation may be achieved.

Such a structure enables stable support of the lower electrical part without a separate fixing structure by utilizing a bottom surface of the electrical case 31 as an installation surface, and may also contribute to simplification of an assembly process and optimization of component dimensions.

In addition, the main circuit part 38 and the power supply circuit part 39 may be disposed adjacent to each other. Accordingly, a power supply path to the main circuit part 38 may be shortened, and a length of wiring through which high current flows may be minimized, thereby reducing power loss and heat generation burden.

As described above, as some or all of the main circuit part 38 or the power supply circuit part 39 are included in the lower electrical part L1, essential circuit configurations required for driving of the cooking appliance may be efficiently secured while reducing a burden on an internal space of the electrical case 31.

In addition, a terminal block 303 connected to an external power source or an external circuit may be installed in the lower electrical part L1. The power supply circuit part 39 may be disposed at a position close to the terminal block 303 even within the lower electrical part L1. Through this, a power inflow path from an external power source may be simplified, and efficiency of wiring work during installation and maintenance may be improved.

The terminal block 303 serves as a relay point for stably connecting power or communication lines introduced from outside to respective circuit parts, and a portion thereof may be formed to protrude below or outward of an external housing 305.

A protruding portion of the terminal block 303 facilitates connection of external connectors and may be protected from external impact and foreign matter intrusion by a terminal case installed below the external housing 305.

The terminal case is installed below the external housing 305 and may be fixed to the external housing 305 through screw fastening or a latching structure. Such a structure allows easy access to the terminal block during on-site installation and maintenance, and enables separation and replacement to be easily performed when necessary.

The external housing 305 may be disposed to be laterally spaced apart from the fan 40 with the opening 12 interposed therebetween. The terminal block 303 and the terminal case installed below the external housing 305 may be disposed below a region, among two regions of the external housing 305 divided in a lateral direction, that is disposed farther from the opening 12 or the fan 40.

As described above, as the terminal case is disposed at a position spaced apart from the fan 40 or the opening 12, concern about physical interference with structures such as the fluid collection part 65 located in the second space S2 may be reduced, and design flexibility of an external power and communication connection structure may be secured.

Furthermore, the electrical part 30b may disperse and dispose the functional circuit parts 33 in the first electrical component space L2 and the second electrical component space L3 in an up-down direction, and at the same time concentrate high-current circuits such as fan driving circuits, the main circuit part 38, and the power supply circuit part 39 in the lower electrical part L1, whereby an internal space and an external space of the electrical case 31 may be efficiently linked according to functions.

Such a structural design enables advancement of an electrical layout, and allows comprehensive system stability encompassing improvement in assembly efficiency as well as heat dispersion performance and maintenance convenience to be secured.

In particular, when sufficient spare space for additionally and distributively arranging electrical components other than a space in which the electrical part 30b is disposed is not available due to a structure of the cooking appliance, the configuration of the electrical part 30b exemplified in the present embodiment may become a very effective solution that enables efficient circuit design even under space constraints.

The embodiments are described above with reference to a number of illustrative embodiments thereof. However, the embodiments are provided as examples, and numerous other modifications and equivalent embodiments can be drawn by one having ordinary skill in the art from the embodiments. Thus, the technical scope of protection of the subject matter of the disclosure is to be defined according to the following claims.

### [Description of Reference Numerals]

1: Support
1a: Countertop
10: Top plate
12: Opening
15: Heating part case
20: Heating part
30, 30b: Electrical part
30a: Main electrical part
31: Electrical case
312: Discharge port
32: Partition member
33: Functional circuit part
331: Heat dissipation member
333: Duct
34: Cooling fan
35: Filter circuit part
36: Motor driving circuit part
37: Motor filter circuit part
38: Main circuit part
39: Power supply circuit part
301a: Sub electrical part
303: Terminal block
305: External housing
L1: First electrical component space
L2: Second electrical component space
40: Fan
41: Impeller
42: Intake port
43: Fan motor
44: Exhaust port
45: Fan housing
47: Fan base
50: First filter
55: Second filter
60: Hood housing
601: Outer wall portion
602: Partition wall
603: Bottom wall portion
605: Inner wall portion
606: Fan accommodating space
607: Upper wall portion
61: Flow path forming portion
611: First filter accommodating portion
612: Connection hole
613: Second filter accommodating portion
63: Fan accommodating portion
65: Fluid collection part
651: Collection protrusion portion
652: Collection space
653: Collection tray
654: Discharge hole
655: Cap
67: Housing cover
d1: First flow path
d2: Second flow path
S: Component arrangement space
S1: First space
S2: Second space

## Claims

1. A cooking appliance comprising:
a top plate covering a component arrangement space; and
an electrical part disposed in the component arrangement space,
wherein the electrical part includes a plurality of functional circuit parts and an electrical case accommodating the functional circuit parts,
wherein an internal space of the electrical case is partitioned into a plurality of electrical component spaces along an up-down direction, and
wherein the plurality of functional circuit parts are respectively disposed in different electrical component spaces.

2. The cooking appliance of claim 1, further comprising a plurality of heating parts heating a heating target object disposed on the top plate,
wherein each of the heating parts is electrically connected to one of the plurality of functional circuit parts.

3. The cooking appliance of claim 1 or 2, wherein each of the functional circuit parts is electrically connected to one or more of the heating parts and includes a plurality of electrical components providing power or control signals for driving the heating parts.

4. The cooking appliance of any one of preceding claims, further comprising a partition member disposed in the electrical component space,
wherein the internal space of the electrical case is partitioned into the plurality of electrical component spaces by the partition member.

5. The cooking appliance of claim 4, wherein the partition member forms a transverse surface extending across the electrical component space in a horizontal direction, and
wherein the electrical component space is partitioned into a first electrical component space disposed between a bottom surface of the electrical case and the partition member, and a second electrical component space disposed above the partition member.

6. The cooking appliance of claim 5, wherein one of the functional circuit parts is installed on the bottom surface of the electrical case and disposed in the first electrical component space, and
wherein another one of the functional circuit parts is installed on the partition member and disposed in the second electrical component space.

7. The cooking appliance of any one of preceding claims, wherein an internal space of the electrical case is partitioned into a first electrical component space and a second electrical component space,
wherein the second electrical component space is disposed above the first electrical component space, and
wherein at least a portion of the functional circuit part disposed in the first electrical component space and at least a portion of the functional circuit part disposed in the second electrical component space are disposed at positions offset from each other in a horizontal direction.

8. The cooking appliance of claim 7, wherein each of the functional circuit parts includes a heat dissipation member on which heat-generating components are installed, and
wherein the heat dissipation member disposed in the first electrical component space and the heat dissipation member disposed in the second electrical component space are disposed at positions offset from each other in a horizontal direction.

9. The cooking appliance of claim 7 or 8,
wherein each of the functional circuit parts includes a first region in which a heat dissipation member on which heat-generating components are installed is disposed, and a second region in which the heat dissipation member is not disposed,
wherein the first region and the second region are arranged in a horizontal direction, and
wherein the second region disposed in the first electrical component space and the second region disposed in the second electrical component space are disposed at positions offset from each other in a horizontal direction.

10. The cooking appliance of claim 1,
wherein an internal space of the electrical case is partitioned into a first electrical component space and a second electrical component space along an up-down direction,
wherein each of the electrical component spaces includes a first space portion and a second space portion partitioned in a horizontal direction,
wherein the functional circuit part is disposed in the first space portion, and
wherein an electrical component other than the functional circuit part is disposed in the second space portion.

11. The cooking appliance of claim 10, further comprising a heating part heating a heating target object disposed on the top plate,
wherein the functional circuit part includes an inverter circuit part provided for driving the heating part, and
wherein at least one of a filter circuit part electrically connected to the inverter circuit part and a cooling fan for cooling the inverter circuit part is disposed in the second space portion.

12. The cooking appliance of claim 10 or 11,
further comprising a fan configured to introduce air into the component arrangement space,
wherein the electrical part further includes a motor driving circuit part provided for driving the fan, and
wherein the motor driving circuit part is disposed in the second space portion.

13. The cooking appliance of claim 12, wherein the electrical part further includes a motor filter circuit part electrically connected to the motor driving circuit part,
wherein the motor driving circuit part is disposed in the second electrical component space, and
wherein the motor filter circuit part is disposed in the first electrical component space and in the second space portion.

14. The cooking appliance of any one of claims 10 to 13, further comprising a main circuit part controlling operation of the functional circuit part, and a power supply circuit part supplying power to the main circuit part,
wherein the power supply circuit part is disposed in the first electrical component space and in the second space portion.

15. The cooking appliance of any one of preceding claims, further comprising a fan configured to introduce air into the component arrangement space,
wherein the top plate includes an opening that opens the component arrangement space,
wherein the component arrangement space includes two partitioned spaces located on both sides of the opening in a horizontal direction,
wherein the fan is disposed in only one of the two partitioned spaces, and
wherein the electrical part is disposed in the partitioned space in which the fan is not disposed.
